# EUROPEAN PATENT APPLICATION

(11) **EP 4 773 774 A1**
(43) Date of publication of application: **08.07.2026**
(21) Application number: 24872930.3
(22) Date of filing: 25.09.2024
(51) Int. Cl.: H10K 59/131, H10K 77/10, G09F 9/30, G06F 1/16, H10K 59/121, G09G 3/32

(54) **DISPLAY DEVICE**

(30) Priority: 26.09.2023 KR 20230129559
(71) Applicant: Samsung Display Co., Ltd., Yongin-si, Gyeonggi-do 17113 (KR)
(72) Inventor: KIM, Hyeong Seok, Yongin-si Gyeonggi-do 17113 (KR); PARK, Hee Jean, Yongin-si Gyeonggi-do 17113 (KR); LEE, Sun Hwa, Yongin-si Gyeonggi-do 17113 (KR); JEON, Mu Kyung, Yongin-si Gyeonggi-do 17113 (KR)
(74) Representative: Walaski, Jan Filip
(86) International application number: PCT/KR2024/014533
(87) International publication number: WO 2025/071222

(57) **Abstract**

A display device includes: a plurality of island portions apart from each other; first bridge portions connecting island portions adjacent to each other in a first direction, the first bridge portions including a first voltage line, a second voltage line, and a third voltage line; and second bridge portions connecting island portions adjacent to each other in a second direction crossing the first direction, the second bridge portions including a fourth voltage line electrically connected to the first voltage line, a fifth voltage line electrically connected to the second voltage line, and a sixth voltage line electrically connected to the third voltage line. The first voltage line and the fourth voltage line are arranged in a first conductive layer. The second voltage line, the fifth voltage line, the third voltage line, and the sixth voltage line are arranged in a second conductive layer on the first conductive layer.

## Description

### Technical Field

One or more embodiments relate to a flexible display device.

### Background Art

With the development of display devices that visually display electrical signals, various display devices having excellent characteristics, such as thinness, light weight, and low power consumption, have been introduced. For example, flexible display devices that are foldable or rollable have been introduced. Recently, stretchable display devices capable of being deformed into various shapes have been under research and development.

### Disclosure of Invention

### Technical Problem

One or more embodiments include a flexible display device, for example, a stretchable display device.

### Solution to Problem

According to one or more embodiments, a display device includes: a plurality of island portions apart from each other; first bridge portions connecting island portions adjacent to each other in a first direction among the plurality of island portions, where the first bridge portions includes a first voltage line, a second voltage line, and a third voltage line; and second bridge portions connecting island portions adjacent to each other in a second direction crossing the first direction among the plurality of island portions, where the second bridge portions includes a fourth voltage line electrically connected to the first voltage line, a fifth voltage line electrically connected to the second voltage line, and a sixth voltage line electrically connected to the third voltage line, where the first voltage line and the fourth voltage line are arranged in a first conductive layer, and the second voltage line, the fifth voltage line, the third voltage line, and the sixth voltage line are arranged in a second conductive layer on the first conductive layer.

In an embodiment, the first voltage line and the fourth voltage line may extend to the plurality of island portions and may be electrically connected to each other.

In an embodiment, the first voltage line may have a first width in a direction perpendicular to an extension direction of the first voltage line, and the fourth voltage line may have a second width greater than the first width in a direction perpendicular to an extension direction of the fourth voltage line.

In an embodiment, the second bridge portions may include only the fourth voltage line in the first conductive layer among the fourth, fifth, and sixth voltage lines.

In an embodiment, the first bridge portions may further include a first initialization voltage line and a second initialization voltage line, and the first initialization voltage line and the second initialization voltage line may be arranged in the first conductive layer.

In an embodiment, each of the plurality of island portions may include voltage connection lines, and the second voltage line and the fifth voltage line may be electrically connected to each other through the voltage connection lines in the plurality of island portions.

In an embodiment, the voltage connection lines may be arranged in a layer that is different from a layer in which the second voltage line and the fifth voltage line are arranged.

In an embodiment, the voltage connection lines may include a first voltage connection line and a second voltage connection line each extending in the first direction, and third voltage connection lines extending in the second direction, the first voltage connection line and the second voltage connection line may be arranged in the first conductive layer, and the third voltage connection line may be arranged in a third conductive layer between the first conductive layer and the second conductive layer.

In an embodiment, the second voltage line and the fifth voltage line may be electrically connected to some of the third voltage connection lines, and the third voltage connection lines may each be electrically connected to the first voltage connection line and the second voltage connection line.

In an embodiment, the third voltage line and the sixth voltage line may extend to the plurality of island portions and may be electrically connected to each other.

In an embodiment, the second voltage line and the fifth voltage line may each have a third width in a direction perpendicular to an extension direction of a corresponding voltage line of the second voltage line and the fifth voltage line, and the third voltage line and the sixth voltage line may each have a fourth width less than the third width in a direction perpendicular to an extension direction of a corresponding voltage line of the third voltage line and the sixth voltage line.

In an embodiment, the fourth voltage line may have a second width greater than the fourth width in the direction perpendicular to the extension direction of the fourth voltage line.

In an embodiment, each of the plurality of island portions may further include a light-emitting element, a first electrode pad electrically connected to a first electrode of the light-emitting element, and a second electrode pad electrically connected to a second electrode of the light-emitting element, and the first electrode pad and the second electrode pad may be arranged in a fourth conductive layer on the second conductive layer.

In an embodiment, each of the plurality of island portions may include a light-emitting element and a pixel driving circuit electrically connected to the light-emitting element, and the pixel driving circuit may include a driving transistor having a gate, a first terminal electrically connected to a first node, and a second terminal, a data write transistor electrically connected to the first node and a data line, a first compensation transistor electrically connected to the gate of the driving transistor and the second terminal of the driving transistor, a first emission control transistor electrically connected to the first node and a second node, a second emission control transistor electrically connected to the light-emitting element and the second terminal of the driving transistor, a third emission control transistor electrically connected to the second node and a driving voltage line, a second compensation transistor electrically connected to the second node and a sustain voltage line, a storage capacitor electrically connected to the second node and the gate of the driving transistor, and an auxiliary capacitor electrically connected to the sustain voltage line and a first electrode of the light-emitting element.

In an embodiment, the sustain voltage line may include the first voltage line and the fourth voltage line.

In an embodiment, the auxiliary capacitor may include a first electrode and a second electrode overlapping the first electrode in a plan view, and the first voltage line and the fourth voltage line may be electrically connected to the second electrode.

In an embodiment, a second electrode of the auxiliary capacitor may be electrically connected to the first electrode of the light-emitting element.

In an embodiment, the driving voltage line may include the second voltage line and the fifth voltage line.

In an embodiment, a second electrode of the light-emitting element may be electrically connected to a common voltage line, and the common voltage line may include the third voltage line and the sixth voltage line.

In an embodiment, each of the plurality of island portions may further include a first electrode pad electrically connected to the first electrode of the light-emitting element and a second electrode pad electrically connected to the second electrode of the light-emitting element, and the third voltage line and the sixth voltage line may extend to the plurality of island portions and are connect to the second electrode pad.

Other aspects, features, and advantages of the disclosure will become better understood through the accompanying drawings, the appended claims, and the detailed description.

### Advantageous Effects of Invention

According to one or more embodiments, a display device that prevents damage due to concentration of stress and expands and contracts in various directions may be provided. These effects are only examples and the scope of the disclosure is not limited by such effects.

### Brief Description of Drawings

FIG. 1 is a perspective view schematically illustrating a stretchable display device according to an embodiment.
FIGS. 2A and 2B are perspective views illustrating the stretchable display device of FIG. 1 stretched in a first direction.
FIG. 2C is a perspective view illustrating the stretchable display device of FIG. 1 stretched in a second direction.
FIG. 2D is a perspective view illustrating the stretchable display device of FIG. 1 stretched in the first and second directions.
FIG. 2E is a perspective view illustrating the stretchable display device of FIG. 1 stretched in a third direction.
FIG. 3 is a plan view schematically illustrating a stretchable display device according to an embodiment.
FIG. 4A is an enlarged plan view of region IV of FIG. 3 as a portion of a stretchable display device according to an embodiment.
FIG. 4B is an enlarged plan view of region IV of FIG. 3 as a portion of a stretchable display device according to an embodiment.
FIG. 4C is an enlarged plan view of region IV of FIG. 3 as a portion of a stretchable display device according to an embodiment.
FIG. 5 is a cross-sectional view schematically illustrating a first island portion and a first bridge portion arranged in a display area of a stretchable display device, according to an embodiment.
FIGS. 6A to 6C are equivalent circuit diagrams of a sub-pixel of a stretchable display device, according to an embodiment.
FIGS. 7A and 7B are cross-sectional views schematically illustrating a light-emitting element of a stretchable display device, according to an embodiment.
FIGS. 8A to 8F are layer-by-layer layout diagrams schematically illustrating an island portion of a stretchable display device, according to an embodiment.
FIG. 9A is a layout diagram schematically illustrating a third conductive layer of a stretchable display device, according to an embodiment.
FIGS. 9B and 9C are layout diagrams schematically illustrating a portion of a third conductive layer of a stretchable display device, according to an embodiment.
FIG. 9D is a layout diagram schematically illustrating a sustain voltage line of a stretchable display device, according to an embodiment.
FIG. 10A is a layout diagram schematically illustrating a fourth conductive layer of a stretchable display device, according to an embodiment.
FIGS. 10B and 10C are layout diagrams schematically illustrating a portion of a fourth conductive layer of a stretchable display device, according to an embodiment.
FIG. 11A is a layout diagram schematically illustrating a fifth conductive layer of a stretchable display device, according to an embodiment.
FIGS. 11B and 11C are layout diagrams schematically illustrating a portion of a fifth conductive layer of a stretchable display device, according to an embodiment.
FIG. 11D is a layout diagram schematically illustrating a driving voltage line of a stretchable display device, according to an embodiment.
FIG. 11E is a layout diagram schematically illustrating a common voltage line of a stretchable display device, according to an embodiment.
FIGS. 12A to 12G are perspective views schematically illustrating an electronic apparatus including a stretchable display device, according to embodiments.

### Best Mode for Carrying out the Invention

According to an embodiment, a display device includes: a plurality of island portions apart from each other; first bridge portions connecting island portions adjacent to each other in a first direction among the plurality of island portions, where the first bridge portions includes a first voltage line, a second voltage line, and a third voltage line; and second bridge portions connecting island portions adjacent to each other in a second direction crossing the first direction among the plurality of island portions, where the second bridge portions includes a fourth voltage line electrically connected to the first voltage line, a fifth voltage line electrically connected to the second voltage line, and a sixth voltage line electrically connected to the third voltage line, where the first voltage line and the fourth voltage line are arranged in a first conductive layer, and the second voltage line, the fifth voltage line, the third voltage line, and the sixth voltage line are arranged in a second conductive layer on the first conductive layer.

### Mode for the Invention

As the present description allows for various changes and numerous embodiments, certain embodiments will be illustrated in the drawings and described in detail in the written description. Effects and features of the disclosure, and methods of achieving them will be clarified with reference to embodiments described below in detail with reference to the drawings. However, the disclosure is not limited to the following embodiments and may be embodied in various forms.

Hereinafter, embodiments will be described in detail with reference to the accompanying drawings. When describing embodiments with reference to the accompanying drawings, the same or corresponding elements are denoted by the same reference numerals.

It will be understood that although the specification, the terms "first," "second," etc. may be used herein to describe various elements, these elements should not be limited by these terms. These terms are only used to distinguish one element from another.

In the present specification, terms such as horizontal, vertical, up, down, left, right, etc. do not have a limiting meaning but are for convenience of explanation and do not indicate absolute orientation. Accordingly, these terms may vary depending on a position of an observer or an arrangement of a display device.

The singular forms "a," "an," and "the" as used herein are intended to include the plural forms as well unless the context clearly indicates otherwise.

It will be further understood that the terms "include" and/or "comprise" used herein specify the presence of stated features or elements, but do not preclude the presence or addition of one or more other features or elements.

It will be further understood that, when a layer, region, or element is referred to as being "on" another layer, region, or element, it may be directly or indirectly on the other layer, region, or element. That is, for example, intervening layers, regions, or elements may be present.

It will be further understood that when layers, regions, or elements are referred to as being connected to each other, they may be directly connected to each other or indirectly connected to each other with intervening layers, regions, or elements therebetween. For example, when layers, regions, or elements are referred to as being electrically connected to each other, they may be directly electrically connected to each other or indirectly electrically connected to each other with intervening layers, regions, or elements therebetween.

Throughout the disclosure, the expression "at least one of A and B" "A and/or B" indicates only A, only B, or both A and B. In this specification, the expression "at least one of A and B" indicates only A, only B, or both A and B.

In the present specification, the x-axis, the y-axis, and the z-axis are not limited to three axes of the rectangular coordinate system and may be interpreted in a broader sense. For example, the x-axis, the y-axis, and the z-axis may be perpendicular to one another or may represent different directions that are not perpendicular to one another.

When a certain embodiment may be implemented differently, a specific process order may be performed differently from the described order. For example, two consecutively described processes may be performed substantially at the same time or performed in an order opposite to the described order.

Also, sizes of elements in the drawings may be exaggerated or reduced for convenience of explanation. For example, because sizes and thicknesses of elements in the drawings are arbitrarily illustrated for convenience of explanation, the disclosure is not limited thereto.

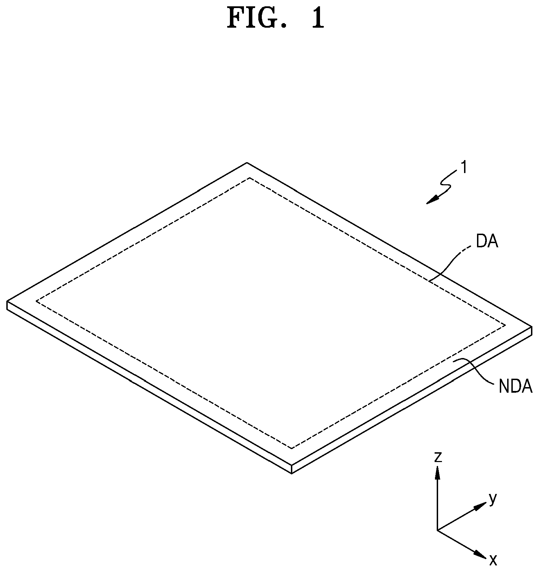

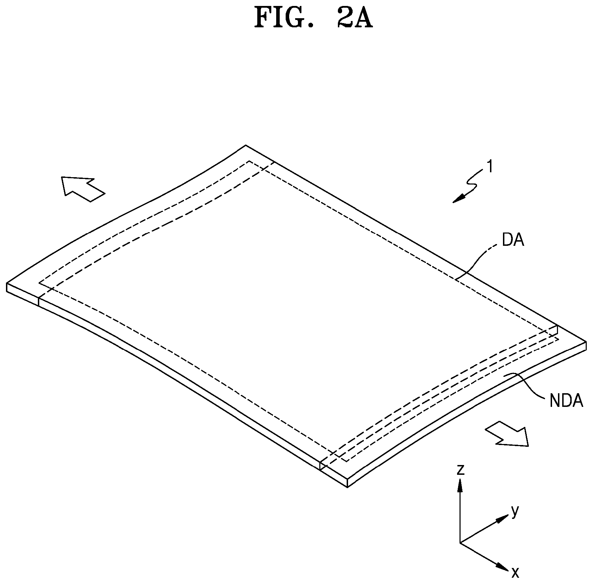

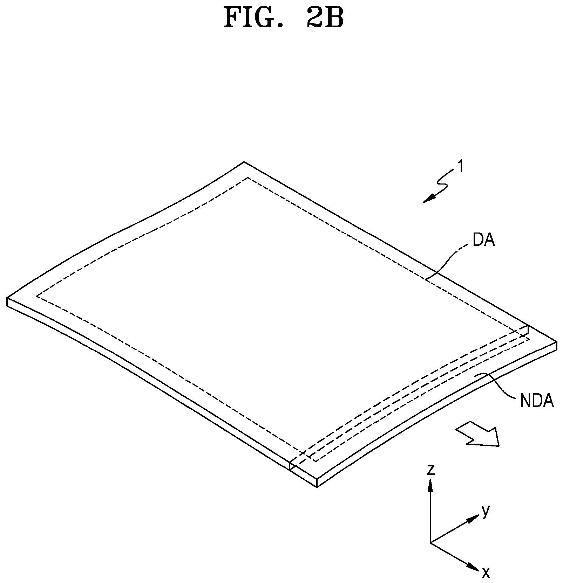

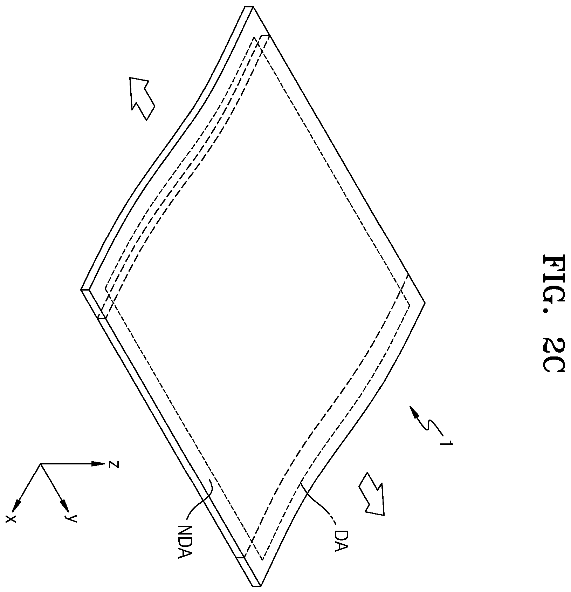

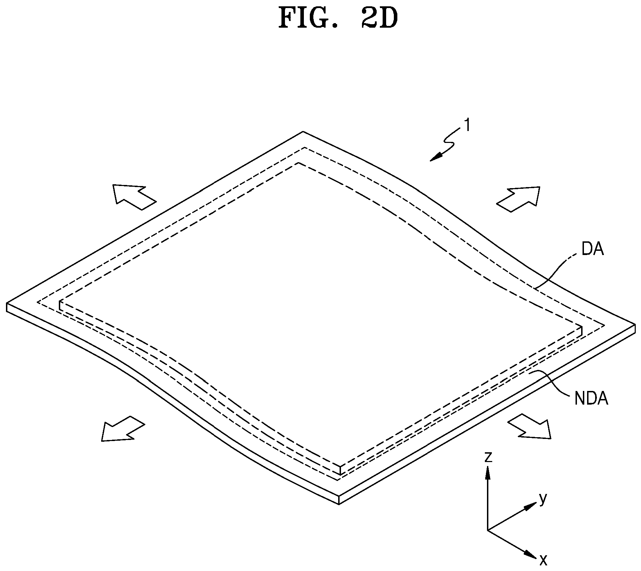

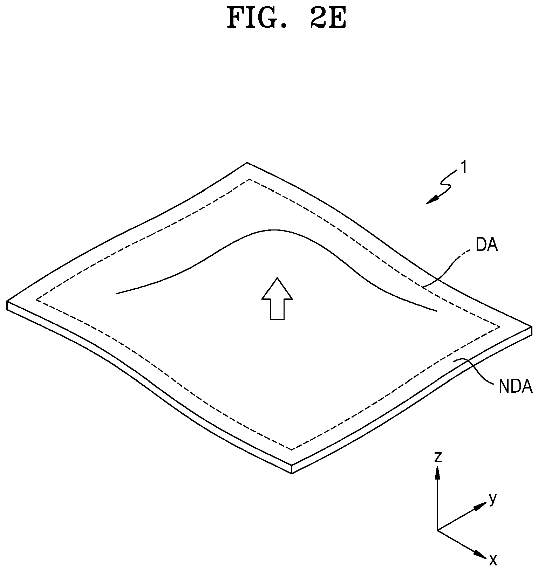

FIG. 1 is a perspective view schematically illustrating a stretchable display device 1 according to an embodiment. FIGS. 2A and 2B are perspective views illustrating the stretchable display device 1 of FIG. 1 stretched in a first direction. FIG. 2C is a perspective view illustrating the stretchable display device 1 of FIG. 1 stretched in a second direction. FIG. 2D is a perspective view illustrating the stretchable display device of FIG. 1 stretched in the first and second directions. FIG. 2E is a perspective view illustrating the stretchable display device 1 of FIG. 1 stretched in a third direction.

Referring to FIG. 1, the stretchable display device 1 may include a display area DA and a non-display area NDA. The display area DA may include a plurality of pixels. The stretchable display device 1 may provide a certain image by using light emitted from the pixels. The non-display area NDA may be outside the display area DA. The non-display area NDA may completely surround the display area DA.

The stretchable display device 1 may be stretched or compressed in various directions. The stretchable display device 1 may be stretched in the first direction (e.g., the +x direction and/or the -x direction) by an external force applied by an external object or a user. In an embodiment, as illustrated in FIGS. 2A and 2B, the display area DA and/or the non-display area NDA of the stretchable display device 1 may be stretched in the first direction (e.g., the +x direction and/or the -x direction). For example, as illustrated in FIG. 2A, the stretchable display device 1 may be stretched in the +x direction and the -x direction, or as illustrated in FIG. 2B, the stretchable display device 1 may be stretched in the +x direction while one side of the stretchable display device 1 is fixed.

The stretchable display device 1 may be stretched in the second direction (e.g., the +y direction and/or the -y direction) by an external force applied by an external object or a user. In an embodiment, as illustrated in FIG. 2C, the display area DA and/or the non-display area NDA of the stretchable display device 1 may be stretched in the +y direction and the -y direction. In another embodiment, the stretchable display device 1 may be stretched in the +y direction or the -y direction while one side of the stretchable display device 1 is fixed.

The stretchable display device 1 may be stretched in a plurality of directions, for example, the first direction (e.g., the +x direction and/or the -x direction) and the second direction (e.g., the +y direction and/or the -y direction) by an external force applied by an external object or a part of a person's body. As illustrated in FIG. 2D, the display area DA and/or the non-display area NDA of the stretchable display device 1 may be stretched in the ±x direction and the ±y direction.

The stretchable display device 1 may be stretched in the third direction (e.g., the +z direction or the -z direction) by an external force applied by an external object or a part of a person's body. In an embodiment, FIG. 2E illustrates that a portion of the stretchable display device 1, for example, a portion of the display area DA protrudes in the +z direction. In another embodiment, a portion of the stretchable display device 1, for example, a portion of the display area DA may protrude in the -z direction (or may be recessed in the +z direction).

FIGS. 2A to 2E illustrate the stretchable display device 1 stretched in the first direction, the second direction, and/or the third direction, but the disclosure is not limited thereto. In another embodiment, the stretchable display device 1 may be deformed into various irregular shapes. For example, the stretchable display device 1 may be bent or twisted with respect to two or more axes.

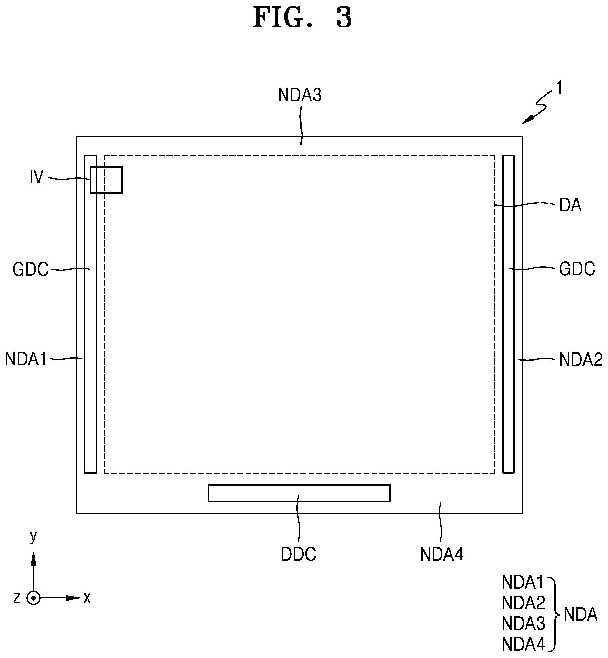

FIG. 3 is a plan view schematically illustrating a stretchable display device 1 according to an embodiment. As used herein, the "plan view" is a view in the third direction (e.g., the +z direction or the -z direction), which is a thickness direction of the stretchable display device 1.

A plurality of pixels may be arranged in a display area DA of the stretchable display device 1. The pixels may each include sub-pixels configured to emit pieces of light of different colors. Light-emitting elements corresponding to the sub-pixels may be arranged in the display area DA. A circuit configured to provide electrical signals to the light-emitting elements arranged in the display area DA and transistors electrically connected to the light-emitting elements may be located in the non-display area NDA surrounding the display area DA. Gate driving circuits GDC may be arranged in a first non-display area NDA1 and a second non-display area NDA2 arranged on opposite sides of the display area DA, respectively. The gate driving circuit GDC may include drivers configured to provide electrical signals to gate electrodes of the transistors electrically connected to the light-emitting elements. Although FIG. 3 illustrates that the gate driving circuits GDC are arranged in the first non-display area NDA1 and the second non-display area NDA2, respectively, the disclosure is not limited thereto. In another embodiment, the gate driving circuit GDC may be arranged in either the first non-display area NDA1 or the second non-display area NDA2.

A data driving circuit DDC may be arranged in a third non-display area NDA3 and/or a fourth non-display area NDA4 connecting the first non-display area NDA1 to the second non-display area NDA2. In an embodiment, FIG. 3 illustrates that the data driving circuit DDC is arranged in the fourth non-display area NDA4. In another embodiment, the data driving circuits DDC may be arranged in the third non-display area NDA3 and the fourth non-display area NDA4, respectively.

Although FIG. 3 illustrates that the data driving circuit DDC is arranged in the fourth non-display area NDA4 of the stretchable display device 1, the disclosure is not limited thereto. In another embodiment, the stretchable display device 1 may further include a flexible circuit board (not shown) electrically connected through a terminal portion (not shown) arranged in the fourth non-display area NDA4, and the data driving circuit DDC may be disposed on the flexible circuit board.

In some embodiments, the elongation rate of the non-display area NDA may be less than or equal to the elongation rate of the display area DA. In an embodiment, the elongation rate of the non-display area NDA may be different for each area. For example, the first non-display area NDA1, the second non-display area NDA2, and the third non-display area NDA3 may have substantially the same elongation rate, but the elongation rate of the fourth non-display area NDA4 may be less than the elongation rate of each of the first non-display area NDA1, the second non-display area NDA2, and the third non-display area NDA3.

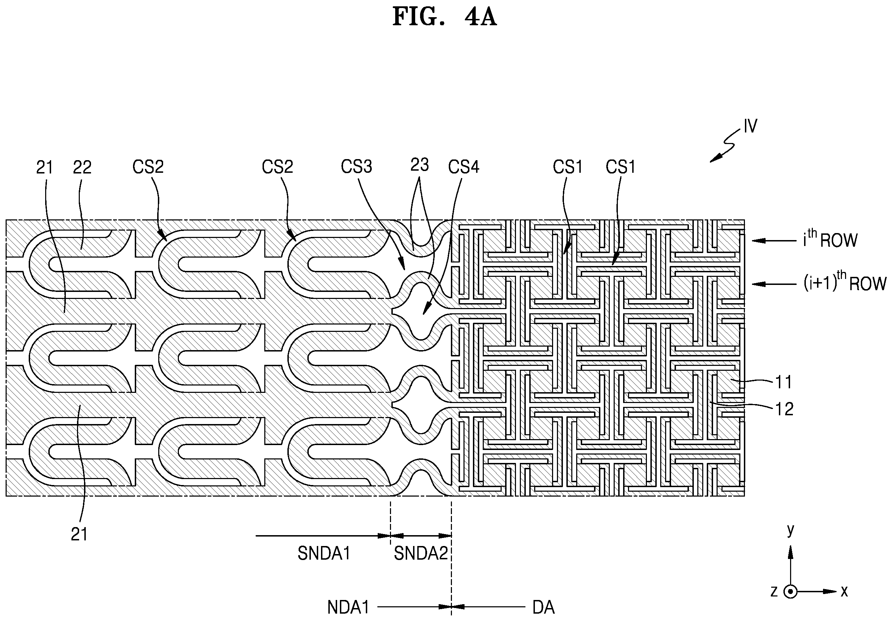

FIG. 4A is an enlarged plan view of region IV of FIG. 3 as a portion of the stretchable display device 1 according to an embodiment.

Referring to FIG. 4A, the stretchable display device 1 may include main island portions 11 apart from each other in the first direction (e.g., the +x direction or the -x direction) and the second direction (e.g., the +y direction or the -y direction) in the display area DA, and main bridge portions 12 connecting the adjacent main island portions 11 to each other.

Each of the main island portions 11 may be connected to a plurality of main bridge portions 12. For example, each of the main island portions 11 may be connected to four main bridge portions 12. The two main bridge portions 12 may be arranged on opposite sides of the main island portion 11 in the first direction (e.g., the +x direction or the -x direction), respectively, and the remaining two main bridge portions 12 may be arranged on opposite sides of the main island portion 11 in the second direction (e.g., the +y direction or the -y direction), respectively. In an embodiment, the four main bridge portions 12 may be connected to four sides of the main island portion 11, respectively. The four main bridge portions 12 may be adjacent to corners of the main island portion 11, respectively.

The main bridge portions 12 may be spaced apart from each other by a first opening CS1 between the main bridge portions 12. In an embodiment, a first opening CS1 having an approximately H shape and a first opening CS1 having an approximately I-shape obtained by rotating the H-shape by 90 degrees may be alternately and repeatedly arranged in the first direction (e.g., the +x direction or the -x direction) and the second direction (e.g., the +y direction or the -y direction). Opposite end portions of each of the main bridge portions 12 may be connected to the adjacent main island portions 11, respectively, and one side of each of the main bridge portions 12 may be spaced apart from one side of the adjacent main island portion 11 and/or one side of another main bridge portion 12 by the first opening CS1.

The stretchable display device 1 may include peripheral island portions 21 apart from each other and peripheral bridge portions 22 connecting the adjacent peripheral island portions 21 to each other in the non-display area, for example, the first non-display area NDA1 illustrated in FIG. 4A.

The peripheral island portions 21 may each extend in the first direction (e.g., the +x direction or the -x direction). The peripheral island portions 21 may be apart from each other in the second direction (e.g., the +y direction or the -y direction) crossing the first direction (e.g., the +x direction or the -x direction). The peripheral island portions 21 may include drivers of the gate driving circuit (see GDC of FIG. 3) described with reference to FIG. 3.

The peripheral bridge portion 22 may have a serpentine shape. The length of the peripheral bridge portion 22 may be greater than the shortest distance between the peripheral island portions 21 adjacent to each other in the second direction (e.g., the +y direction or the -y direction). In an embodiment, the peripheral bridge portion 22 may have an approximately omega (Ω) shape that is convex in the first direction (e.g., the +x direction or the -x direction). The peripheral bridge portions 22 may be between the peripheral island portions 21 adjacent to each other and may be apart from each other.

The peripheral bridge portions 22 between the peripheral island portions 21 adjacent to each other may be spaced apart from each other by the second opening CS2. The second openings CS2 and the peripheral bridge portions 22 may be alternately arranged in the first direction (e.g., the +x direction or the -x direction) between the peripheral island portions 21 adjacent to each other. The second openings CS2 may have the same shape. Opposite end portions of each of the peripheral bridge portions 22 may be connected to the adjacent peripheral island portions 21, respectively, and one side of each of the peripheral bridge portions 22 may be spaced apart from one side of the adjacent peripheral island portion 21 and/or one side of another peripheral bridge portion 22 by the second opening CS2.

One peripheral island portion 21 arranged in the first non-display area NDA1 may correspond to a plurality of rows of main island portions 11 arranged in the display area DA1. For example, one peripheral island portion 21 arranged in the first non-display area NDA1 may correspond to main island portions 11 arranged in an i^{th} row and main island portions 11 arranged in an (i+1)^{th} row in the display area DA (where i is a positive number greater than 0). Although FIG. 4A illustrates that one peripheral island portion 21 corresponds to two rows of main island portions 11, the disclosure is not limited thereto. In another embodiment, one peripheral island portion 21 arranged in the first non-display area NDA1 may correspond to n rows of the main island portions 11 arranged in the display area DA1 (where n is a positive number greater than or equal to 3).

The non-display area, for example, the first non-display area NDA1 may include a first sub-non-display area SNDA1 in which the peripheral island portions 21 and the peripheral bridge portions 22 are arranged, and a second sub-non-display area SNDA2 between the first sub-non-display area SNDA1 and the display area DA. Connection bridge portions 23 may be arranged in the second sub-non-display area SNDA2 so as to connect the display area DA to the first sub-non-display area SNDA1. One end portion of the connection bridge portion 23 may be connected to the peripheral island portion 21 and/or the peripheral bridge portion 22, and the other end portion of the connection bridge portion 23 may be connected to the main island portion 11 and/or the main bridge portion 12.

The connection bridge portion 23 may have a serpentine shape. In an embodiment, the shape of the connection bridge portion 23 may be different from the shape of the main bridge portion 12 and the shape of the peripheral bridge portion 22. In an embodiment, as illustrated in FIG. 4A, the connection bridge portion 23 may have an approximately omega (Ω) shape that is convex in the second direction (e.g., the +y direction or the -y direction). The connection bridge portions 23 may have a symmetrical structure in which one of the adjacent connection bridge portions 23 arranged in the second direction (e.g., the +y direction or the -y direction) is convex in the +y direction and the other thereof is convex in the -y direction. The third openings CS3 and the fourth openings CS4 having different shapes from each other may be repeated between the connection bridge portions 23. The width of the connection bridge portion 23 may be different from the width of the main bridge portion 12 and the width of the peripheral bridge portion 22. In an embodiment, the width of the connection bridge portion 23 may be greater than the width of the main bridge portion 12 and less than the width of the peripheral bridge portion 22.

FIG. 4A illustrates that the peripheral island portion 21 and the peripheral bridge portion 22 in the non-display area, for example, the first non-display area NDA1, have different shapes from the main island portion 11 and the main bridge portion 12 in the display area DA. In another embodiment, the peripheral island portion 21 and the peripheral bridge portion 22 in the non-display area may have the same shape as the main island portion 11 and the main bridge portion 12 in the display area DA, respectively.

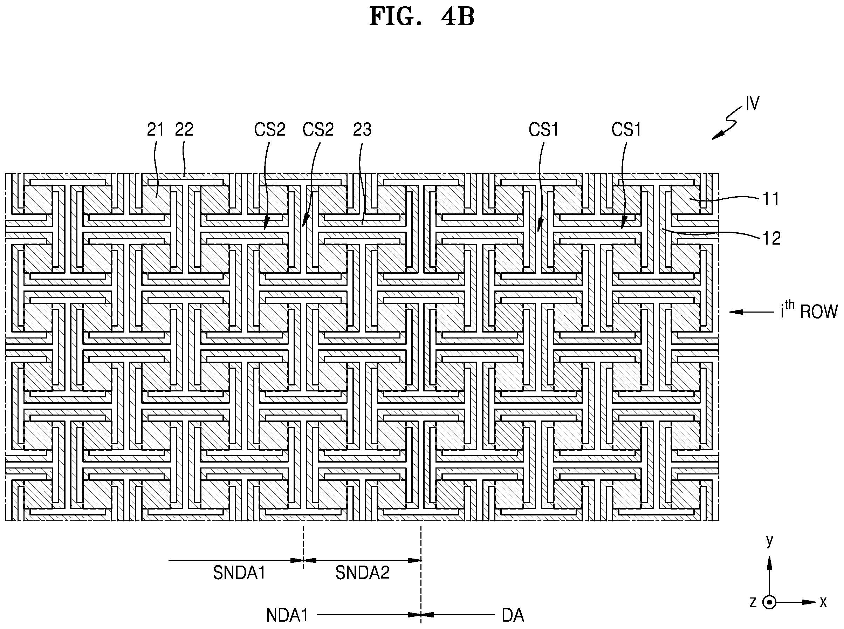

FIG. 4B is an enlarged plan view of region IV of FIG. 3 as a portion of the stretchable display device 1 according to an embodiment.

Referring to FIG. 4B, the stretchable display device 1 may include main island portions 11 apart from each other in a display area DA, and main bridge portions 12 spaced apart from each other by first openings CS1 and connecting the adjacent main island portions 11 to each other. The structure of the display area DA in FIG. 4B may be the same as the structure of the display area DA described with reference to FIG. 4A.

The stretchable display device 1 may include peripheral island portions 21 and peripheral bridge portions 22 arranged in a non-display area, for example, a first non-display area NDA1. In an embodiment, the peripheral island portions 21 and the peripheral bridge portions 22 may have substantially the same shape as the main island portions 11 and the main bridge portions 12, respectively.

The peripheral island portions 21 may be apart from each other in the first direction (e.g., the +x direction or the -x direction) and the second direction (e.g., the +y direction or the -y direction) in the non-display area, for example, the first non-display area NDA1. The peripheral bridge portions 22 may each connect the adjacent peripheral island portions 21 to each other. The peripheral bridge portions 22 may be spaced apart from each other by a second opening CS2 between the peripheral bridge portions 22.

The second opening CS2 may have substantially the same shape as the first opening CS1. For example, the approximately H-shaped second opening CS2 and the approximately I-shaped second opening CS2 may be alternately and repeatedly arranged in the non-display area, for example, the first non-display area NDA1. Opposite end portions of each of the peripheral bridge portions 22 may be connected to the adjacent peripheral island portions 21, respectively, and one side of each of the peripheral bridge portions 22 may be spaced apart from one side of the adjacent peripheral island portion 21 and/or one side of another peripheral bridge portion 22 by the second opening CS2.

Each of the peripheral island portions 21 may be connected to four peripheral bridge portions 22. The peripheral island portions 21 may include drivers of the gate driving circuit (see GDC of FIG. 3) described with reference to FIG. 3.

One row of the peripheral island portions 21 arranged in the first non-display area NDA1 may correspond to one row of the main island portions 11 arranged in the display area DA1. For example, the peripheral island portions 21 arranged in the i^{th} row in the first direction (e.g., the +x direction or the -x direction) in the first non-display area NDA1 may correspond to the main island portions 11 arranged in the same row, for example, the i^{th} row, in the display area DA (where i is a positive number greater than 0).

The stretchable display device 1 may include connection bridge portions 23 arranged in the second sub-non-display area SNDA2 so as to connect the display area DA to the first sub-non-display area SNDA1. The non-display area, for example, the first non-display area NDA1 may include a first sub-non-display area SNDA1 in which the peripheral island portions 21 and the peripheral bridge portions 22 are arranged, and a second sub-non-display area SNDA2 between the first sub-non-display area SNDA1 and the display area DA and including the connection bridge portions 23. The connection bridge portion 23 may be substantially the same as the main bridge portion 12 and the peripheral bridge portion 22. For example, the width of the connection bridge portion 23 may be equal to the width of the main bridge portion 12 and the width of the peripheral bridge portion 22.

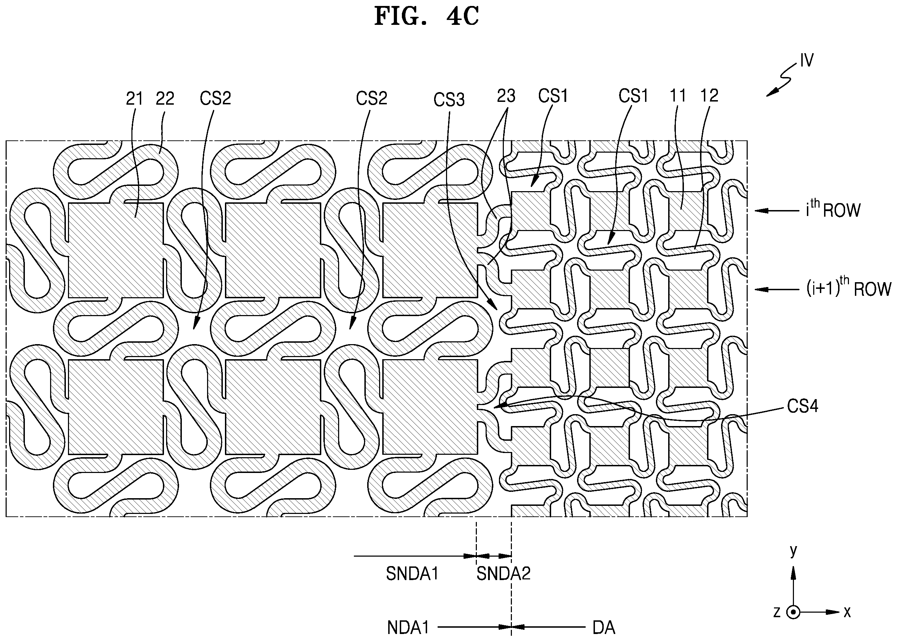

FIG. 4C is an enlarged plan view of region IV of FIG. 3 as a portion of the stretchable display device 1 according to an embodiment.

Referring to FIG. 4C, the stretchable display device 1 may include main island portions 11 apart from each other in the first direction (e.g., the +x direction or the -x direction) and the second direction (e.g., the +y direction or the -y direction) in the display area DA, and main bridge portions 12 connecting the adjacent main island portions 11 to each other.

The main bridge portions 12 may be spaced apart from each other by a first opening CS1 between the main bridge portions 12. The main bridge portion 12 may have a serpentine shape. For example, as illustrated in FIG. 4C, the main bridge portion 12 may have an approximately S shape.

Each of the main island portions 11 may be connected to a plurality of main bridge portions 12. For example, each of the main island portions 11 may be connected to four main bridge portions 12. The two main bridge portions 12 may be arranged on opposite sides of the main island portion 11 in the first direction (e.g., the +x direction or the -x direction), respectively, and the remaining two main bridge portions 12 may be arranged on opposite sides of the main island portion 11 in the second direction (e.g., the +y direction or the -y direction), respectively. The four main bridge portions 12 may be connected to four sides of the main island portion 11, respectively. The four main bridge portions 12 may be adjacent to corners of the main island portion 11, respectively.

The stretchable display device 1 may include peripheral island portions 21 apart from each other in the first direction (e.g., the +x direction or the -x direction) and the second direction (e.g., the +y direction or the -y direction) in the non-display area, for example, the first non-display area NDA1 illustrated in FIG. 4C, and peripheral bridge portions 22 connecting the adjacent peripheral island portions 21 to each other.

The peripheral bridge portions 22 may be spaced apart from each other by a second opening CS2 between the peripheral bridge portions 22. The peripheral bridge portion 22 may have a serpentine shape. For example, as illustrated in FIG. 4C, the peripheral bridge portion 22 may have an approximately S shape. The size and/or width of the peripheral bridge portion 22 may be different from the size and/or width of the main bridge portion 12. For example, the size and/or width of the peripheral bridge portion 22 may be greater than the size and/or width of the main bridge portion 12. The radius of curvature of the round portion of the peripheral bridge portion 22 may be different from the radius of curvature of the round portion of the main bridge portion 12. For example, the radius of curvature of the round portion of the peripheral bridge portion 22 may be greater than the radius of curvature of the round portion of the main bridge portion 12.

Each of the peripheral island portions 21 may be connected to a plurality of peripheral bridge portions 22. Each of the peripheral island portions 21 may be connected to four peripheral bridge portions 22. The two peripheral bridge portions 22 may be arranged on opposite sides of the peripheral island portion 21 in the first direction (e.g., the +x direction or the -x direction), respectively, and the remaining two peripheral bridge portions 22 may be arranged on opposite sides of the peripheral island portion 21 in the second direction (e.g., the +y direction or the -y direction), respectively. In an embodiment, the four peripheral bridge portions 22 may be connected to four sides of the peripheral island portion 21, respectively. The peripheral bridge portions 22 may be connected to the central portions of the sides of the peripheral island portion 21, respectively.

One row of peripheral island portions 21 arranged in the first non-display area NDA1 may correspond to a plurality of rows of main island portions 11 arranged in the display area DA1. For example, one row of peripheral island portions 21 arranged in the first non-display area NDA1 may correspond to main island portions 11 arranged in an i^{th} row and main island portions 11 arranged in an (i+1)^{th} row in the display area DA (where i is a positive number greater than 0). In another embodiment, one row of the peripheral island portions 21 may correspond to n rows of main island portions 11 (where n is a positive number greater than or equal to 3).

The non-display area, for example, the first non-display area NDA1 may include a first sub-non-display area SNDA1 in which the peripheral island portions 21 and the peripheral bridge portions 22 are arranged, and a second sub-non-display area SNDA2 between the first sub-non-display area SNDA1 and the display area DA. Connection bridge portions 23 may be arranged in the second sub-non-display area SNDA2 so as to connect the display area DA to the first sub-non-display area SNDA1. One end portion of the connection bridge portion 23 may be connected to the peripheral island portion 21, and the other end portion of the connection bridge portion 23 may be connected to the main island portion 11. For example, one end portion of the connection bridge portion 23 may be connected to the central portion of one side of the peripheral island portion 21, and the other end portion of the connection bridge portion 23 may be connected to the central portion of one side of the main island portion 11.

The connection bridge portion 23 may have a serpentine shape. In an embodiment, the shape of the connection bridge portion 23 may be different from the shape of the main bridge portion 12 and the shape of the peripheral bridge portion 22. The width of the connection bridge portion 23 may be different from the width of the main bridge portion 12 and the width of the peripheral bridge portion 22. The width of the connection bridge portion 23 may be greater than the width of the main bridge portion 12 and less than the width of the peripheral bridge portion 22. Third openings CS3 and fourth openings CS4 having different shapes may be alternately between the connection bridge portions 23 in the second direction (e.g., the +y direction or the -y direction).

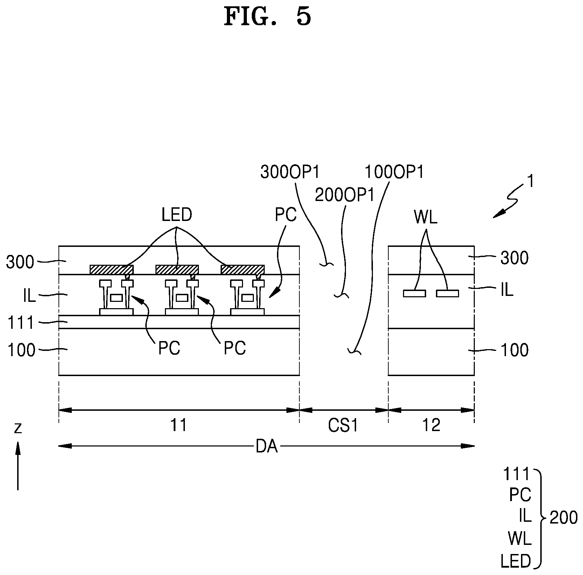

FIG. 5 is a cross-sectional view schematically illustrating the main island portion 11 and the main bridge portion 12 arranged in the display area DA of the stretchable display device 1, according to an embodiment.

Referring to FIG. 5, the main island portion 11 and the main bridge portion 12 in the display area DA may be apart from each other with the first opening CS1 therebetween. The main island portion 11 may include light-emitting elements LED and a circuit configured to drive the light-emitting elements electrically connected thereto, for example, a pixel driving circuit PC. The main bridge portion 12 may include auxiliary capacitors Ca electrically connected to the pixel driving circuits PC arranged in the adjacent main island portions 11, respectively.

In the main island portion 11, a buffer layer 111 including an inorganic insulating material may be disposed on a substrate 100, and the pixel driving circuit PC may be disposed on the buffer layer 111. An insulating layer IL including an inorganic insulating material and/or an organic insulating material may be between the pixel driving circuits PC and the light-emitting elements LED. The light-emitting element LED may be disposed on the insulating layer IL and may be electrically connected to the corresponding pixel driving circuit PC. The light-emitting elements LED may be configured to emit pieces of light of different colors or the same color. In an embodiment, the light-emitting elements LED may be configured to emit red light, green light, and blue light. In some embodiments, the light-emitting elements LED may be configured to emit white light. In another embodiment, the light-emitting elements LED may be configured to emit red light, green light, blue light, and white light.

The substrate 100 may include polymer resin, such as polyethersulfone, polyarylate, polyether imide, polyethylene naphthalate, polyethylene terephthalate, polyphenylene sulfide, polyimide, polycarbonate, cellulose triacetate, cellulose acetate, or propionate. In an embodiment, the substrate 100 may be a single layer including the polymer resin described above. In another embodiment, the substrate 100 may have a multilayer structure including a base layer including the polymer resin described above and a barrier layer including an inorganic insulating material. The substrate 100 including the polymer resin may be flexible, rollable, and bendable.

In an embodiment, although FIG. 5 illustrates that three pixel driving circuits PC arranged in each of the main island portions 11 and three light-emitting elements LED are connected to the three pixel driving circuits PC, respectively, the disclosure is not limited thereto. In another embodiment, the number of pixel driving circuits PC and light-emitting elements LED arranged in the main island portion 11 may be one, two, or four or more.

An encapsulation layer 300 may be disposed on the light-emitting elements LED and may protect the light-emitting elements LED from an external force and/or moisture penetration. The encapsulation layer 300 may include an inorganic encapsulation layer and/or an organic encapsulation layer. In some embodiments, the encapsulation layer 300 may include a structure in which an inorganic encapsulation layer including an inorganic insulating material, an organic encapsulating layer including an organic insulating material, and an inorganic encapsulating layer including an inorganic insulating material are stacked in this stated order. In another embodiment, the encapsulation layer 300 may include an organic material such as resin. In some embodiments, the encapsulation layer 300 may include urethane epoxy acrylate. The encapsulation layer 300 may include a photosensitive material such as photoresist.

In the main bridge portion 12, an insulating layer IL including an organic insulating material may be disposed on the substrate 100. When the stretchable display device 1 is stretched, the main bridge portion 12, which is relatively deformed, may not have a layer including an inorganic insulating material that is prone to cracks, unlike the main island portion 11.

In an embodiment, the substrate 100 corresponding to the main bridge portion 12 may have the same stack structure as the substrate 100 corresponding to the main island portion 11. In an embodiment, the substrate 100 corresponding to the main bridge portion 12 and the substrate 100 corresponding to the main island portion 11 may be polymer resin layers formed together in the same process. In another embodiment, the substrate 100 corresponding to the main bridge portion 12 may have a different stack structure from the substrate 100 corresponding to the main island portion 11. In some embodiments, the substrate 100 corresponding to the main bridge portion 12 may have a multilayer structure including a base layer including polymer resin and a barrier layer including an inorganic insulating material, and the substrate 100 corresponding to the main bridge portion 12 may have a structure of a polymer resin layer without a layer including an inorganic insulating material.

The wirings WL of the main bridge portion 12 may be a signal line (e.g., a gate line, a data line, etc.) configured to provide an electrical signal to the transistor included in the pixel driving circuit PC of the main island portion 11, or may be a voltage line (e.g., a driving voltage line, an initialization voltage line, etc.) configured to provide a voltage to the transistor included in the pixel driving circuit PC of the main island portion 11. The encapsulation layer 300 may also be arranged in the main bridge portion 12. In another embodiment, the encapsulation layer 300 may not be present in the main bridge portion 12.

Referring to FIGS. 4A to 4C and FIG. 5, the substrate 100 corresponding to the main island portion 11 and the substrate 100 corresponding to the main bridge portion 12 may be connected to each other. In other words, the plan views illustrated in FIGS. 4A to 4C may be substantially the same as the plan view of the substrate 100 in FIG. 5. In other words, the substrate 100 may include an area corresponding to the main island portion 11, an area corresponding to the main bridge portion 12, and an opening 100OP1 having the same shape as the first opening CS1.

Similarly, the encapsulation layer 300 corresponding to the main island portion 11 and the encapsulation layer 300 corresponding to the main bridge portion 12 may be connected to each other. For example, the plan views illustrated in FIGS. 4A to 4C may be substantially the same as the plan view of the encapsulation layer 300. In other words, the encapsulation layer 300 may include an area corresponding to the main island portion 11, an area corresponding to the main bridge portion 12, and an opening 300OP1 having the same shape as the first opening CS1.

A circuit light-emitting element layer 200 between the substrate 100 and the encapsulation layer 300 may include a buffer layer 111, a pixel driving circuit PC, a wiring WL, an insulating layer IL, and a light-emitting element LED. Similar to the substrate 100, the plan views illustrated in FIGS. 4A to 4C may be substantially the same as the plan view of the circuit light-emitting element layer 200. In other words, the circuit light-emitting element layer 200 may include an opening 200OP1 having the same shape as the first opening CS1.

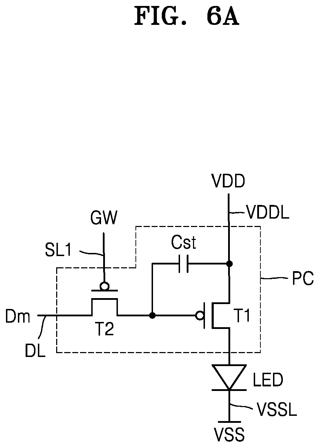

FIGS. 6A to 6C are equivalent circuit diagrams of a sub-pixel of a stretchable display device 1, according to an embodiment.

Referring to FIG. 6A, a light-emitting element LED corresponding to the sub-pixel may be electrically connected to a pixel driving circuit PC, and the pixel driving circuit PC may include a first transistor T1, a second transistor T2, and a storage capacitor Cst. The pixel driving circuit PC may be electrically connected to signal lines and voltage lines. The signal lines may include a gate line, such as a first scan line SL1, and a data line DL, and the voltage lines may include a driving voltage line VDDL.

The second transistor T2 may be electrically connected to the first scan line SL1 and the data line DL. The first scan line SL1 may be configured to provide a first scan signal GW to a gate electrode of the second transistor T2. The second transistor T2 may be configured to transmit, to the first transistor T1, a data signal Dm input from the data line DL in response to the first scan signal GW input from the first scan line SL1.

The storage capacitor Cst may be electrically connected to the second transistor T2 and the driving voltage line VDDL and may be configured to store a voltage corresponding to a difference between a voltage received from the second transistor T2 and a driving power supply voltage VDD supplied through the driving voltage line VDDL.

The first transistor T1 may act as a "driving transistor" and may be configured to control a driving current flowing through the light-emitting element LED. The first transistor T1 may be connected to the driving voltage line VDDL and the storage capacitor Cst. The first transistor T1 may be configured to control a driving current flowing from the driving voltage line VDDL to the light-emitting element LED according to a voltage value stored in the storage capacitor Cst. The light-emitting element LED may be configured to emit light having a certain luminance according to the driving current. A first electrode of the light-emitting element LED may be electrically connected to the first transistor T1, and a second electrode of the light-emitting element LED may be electrically connected to a common voltage line VSSL configured to supply a common power supply voltage VSS.

FIG. 6A illustrates that the pixel driving circuit PC includes two transistors and one storage capacitor, but in another embodiment, the pixel driving circuit PC may include three or more transistors.

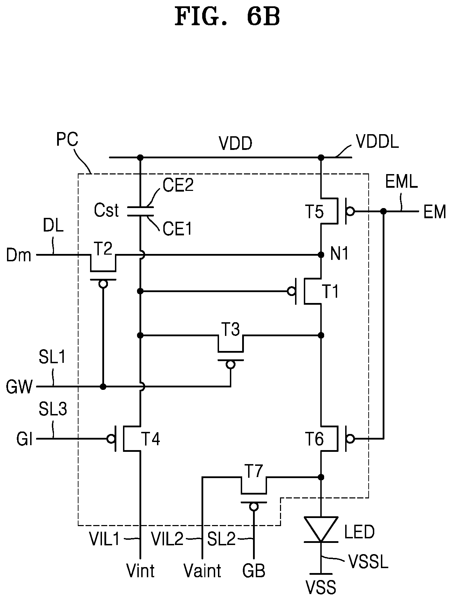

Referring to FIG. 6B, the pixel driving circuit PC may include a first transistor T1, a second transistor T2, a third transistor T3, a fourth transistor T4, a fifth transistor T5, a sixth transistor T6, a seventh transistor T7, and a storage capacitor Cst.

The pixel driving circuit PC may be electrically connected to signal lines and voltage lines. The signal lines may include a data line DL and gate lines, such as a first scan line SL1, a second scan line SL2, a third scan line SL3, and an emission control line EML. The voltage lines may include first and second initialization voltage lines VIL1 and VIL2 and a driving voltage line VDDL.

The driving voltage line VDDL may be configured to transmit a driving power supply voltage VDD to the first transistor T1. The first initialization voltage line VIL1 may be configured to transmit, to the pixel driving circuit PC, a first initialization voltage Vint for initializing the first transistor T1. The second initialization voltage line VIL2 may be configured to transmit, to the pixel driving circuit PC, a second initialization voltage Vaint for initializing a first electrode of a light-emitting element LED.

The first transistor T1 may be electrically connected to the driving voltage line VDDL via the fifth transistor T5 and may be electrically connected to the light-emitting element LED via the sixth transistor T6. The first transistor T1 may act as a driving transistor and may be configured to receive a data signal Dm according to the switching operation of the second transistor T2 and supply a driving current to the light-emitting element LED.

The second transistor T2 may act as a "data write transistor" and may be electrically connected to the first scan line SL1 and the data line DL. The second transistor T2 may be electrically connected to the driving voltage line VDDL via the fifth transistor T5. The second transistor T2 may be configured to be turned on in response to a first scan signal GW received through the first scan line SL1 and perform a switching operation to transmit the data signal Dm received through the data line DL to a first node N1.

The third transistor T3 may be electrically connected to the first scan line SL1 and electrically connected to the light-emitting element LED via the sixth transistor T6. The third transistor T3 may be configured to be turned on in response to the first scan signal GW received through the first scan line SL1 and diode-connect the first transistor T1.

The fourth transistor T4 may act as a first initialization transistor and may be electrically connected to the third scan line SL3 and the first initialization voltage line VIL1. The fourth transistor T4 may be configured to be turned on in response to a third scan signal GI received through the third scan line SL3 and initialize the voltage of the gate electrode of the first transistor T1 by transmitting the first initialization voltage Vint from the first initialization voltage line VIL1 to the gate electrode of the first transistor T1. The third scan signal GI may correspond to the first scan signal of another pixel driving circuit arranged in the previous row of the corresponding pixel driving circuit PC.

The fifth transistor T5 may act as an operation control transistor, and the sixth transistor T6 may act as an emission control transistor. The fifth transistor T5 and the sixth transistor T6 may be electrically connected to the emission control line EML and may be configured to be simultaneously turned on in response to an emission control signal EM received through the emission control line EML and form a current path through which the driving current flows in a direction from the driving voltage line VDDL to the light-emitting element LED.

The seventh transistor T7 may act as a second initialization transistor and may be electrically connected to the second scan line SL2, the second initialization voltage line VIL2, and the sixth transistor T6. The seventh transistor T7 may be configured to be turned on in response to a second scan signal GB received through the second scan line SL2 and initialize the first electrode of the light-emitting element LED by transmitting the second initialization voltage Vaint from the second initialization voltage line VIL2 to the first electrode of the light-emitting element LED.

The storage capacitor Cst may include a first electrode CE1 and a second electrode CE2. The first electrode CE1 may be electrically connected to the gate electrode of the first transistor T1, and the second electrode CE2 may be electrically connected to the driving voltage line VDDL. The storage capacitor Cst may store and maintain a voltage corresponding to a voltage difference between the driving voltage line VDDL and the gate electrode of the first transistor T1, and thus, the voltage applied to the gate electrode of the first transistor T1 may be maintained.

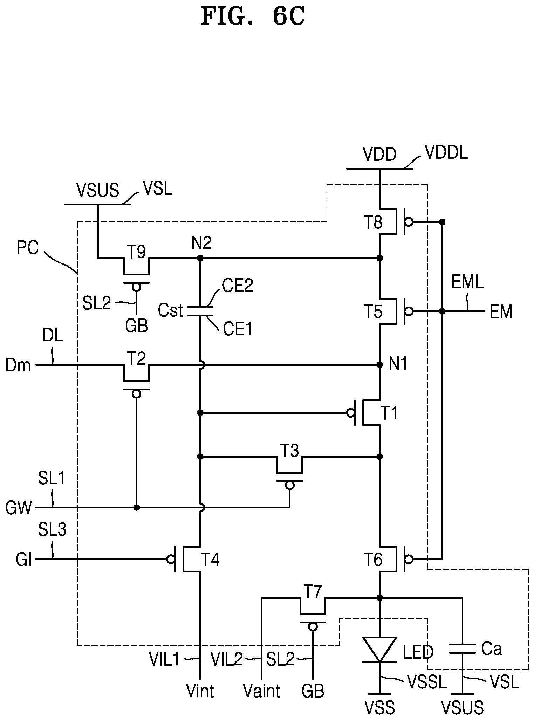

Referring to FIG. 6C, the pixel driving circuit PC may include a first transistor T1 (a "driving transistor"), a second transistor T2 (a "data write transistor"), a third transistor T3 (a "first compensation transistor"), a fourth transistor T4 (a "first initialization transistor"), a fifth transistor T5 (a "first emission control transistor"), a sixth transistor T6 (a "second emission control transistor"), a seventh transistor T7 (a "second initialization transistor"), an eighth transistor T8 (a "third emission control transistor"), a ninth transistor T9 (a "second compensation transistor"), a storage capacitor Cst, and an auxiliary capacitor Ca.

The pixel driving circuit PC may be electrically connected to signal lines and voltage lines. The signal lines may include a data line DL and gate lines, such as a first scan line SL1, a second scan line SL2, a third scan line SL3, and an emission control line EML. The voltage lines may include first and second initialization voltage lines VIL1 and VIL2, a sustain voltage line VSL, and a driving voltage line VDDL.

The driving voltage line VDDL may be configured to transmit a driving power supply voltage VDD to the first transistor T1. The first initialization voltage line VIL1 may be configured to transmit, to the pixel driving circuit PC, a first initialization voltage Vint for initializing the first transistor T1. The second initialization voltage line VIL2 may be configured to transmit, to the pixel driving circuit PC, a second initialization voltage Vaint for initializing a first electrode of a light-emitting element LED. The sustain voltage line VSL may be configured to provide a sustain voltage VSUS to a second node N2, for example, a second electrode CE2 of the storage capacitor Cst, in an initialization period and a data write period.

The first transistor T1 may have a gate, a first terminal electrically connected to a first node N1, and a second terminal. The first terminal of the first transistor T1 may be electrically connected to the driving voltage line VDDL via the fifth transistor T5 and the eighth transistor T8, and the second terminal of the first transistor T1 may be electrically connected to the light-emitting element LED via the sixth transistor T6. The first transistor T1 may act as a driving transistor and may be configured to receive a data signal Dm according to the switching operation of the second transistor T2 and supply a driving current to the light-emitting element LED.

The second transistor T2 may be electrically connected to the first scan line SL1, the data line DL, and the first node N1. The second transistor T2 may be electrically connected to the driving voltage line VDDL through the first node N1 via the fifth transistor T5 and the eighth transistor T8. The second transistor T2 may be configured to be turned on in response to a first scan signal GW received through the first scan line SL1 and perform a switching operation to transmit, to the first node N1, the data signal Dm transmitted through the data line DL.

The third transistor T3 may be electrically connected to a gate of the first transistor T1 and the second terminal of the first transistor T1. A gate of the third transistor T3 may be electrically connected to the first scan line SL1 and electrically connected to the light-emitting element LED via the sixth transistor T6. The third transistor T3 may be configured to be turned on in response to the first scan signal GW received through the first scan line SL1 and compensate for a threshold voltage of the first transistor T1 by diode-connecting the first transistor T1.

The fourth transistor T4 may be electrically connected to the third scan line SL3 and the first initialization voltage line VIL1 and may be configured to be turned on in response to a third scan signal GI received through the third scan line SL3 and initialize the voltage of the gate electrode of the first transistor T1 by transmitting the first initialization voltage Vint from the first initialization voltage line VIL1 to the gate electrode of the first transistor T1. The third scan signal GI may correspond to the first scan signal of another pixel driving circuit arranged in the previous row of the corresponding pixel driving circuit PC.

The fifth transistor T5 may be electrically connected to the first node N1 and the second node N2, the sixth transistor T6 may be electrically connected to the second terminal of the first transistor T1 and the light-emitting element LED, and the eighth transistor T8 may be electrically connected to the second node N2 and the driving voltage line VDDL. The fifth transistor T5, the sixth transistor T6, and the eighth transistor T8 may be electrically connected to the emission control line EML and may be configured to be simultaneously turned on in response to an emission control signal EM received through the emission control line EML and form a current path through which the driving current flows in a direction from the driving voltage line VDDL to the light-emitting element LED.

The seventh transistor T7 may act as a second initialization transistor and may be electrically connected to the second scan line SL2, the second initialization voltage line VIL2, and the sixth transistor T6. The seventh transistor T7 may be configured to be turned on in response to a second scan signal GB received through the second scan line SL2 and initialize the first electrode of the light-emitting element LED by transmitting the second initialization voltage Vaint from the second initialization voltage line VIL2 to the first electrode of the light-emitting element LED.

The ninth transistor T9 may be electrically connected to the second scan line SL2, the node N2, and the sustain voltage line VSL. The ninth transistor T9 may be electrically connected to the second electrode CE2 of the storage capacitor Cst through the second node N2. The ninth transistor T9 may be configured to be turned on in response to the second scan signal GB received through the second scan line SL2 and transmit the sustain voltage VSUS to the second node N2, for example, the second electrode CE2 of the storage capacitor Cst, in an initialization period and a data write period.

The eighth transistor T8 and the ninth transistor T9 may be electrically connected to the second node N2, for example, the second electrode CE2 of the storage capacitor Cst. In some embodiments, in the initialization period and the data write period, the eighth transistor T8 may be turned off and the ninth transistor T9 may be turned on, and in the emission period, the eighth transistor T8 may be turned on and the ninth transistor T9 may be turned off. Because the sustain voltage VSUS is transmitted to the second node N2 in the initialization period and the data write period, the luminance uniformity (e.g., long range uniformity ("LRU")) of the stretchable display device according to the voltage drop in the driving voltage line VDDL may be improved.

The storage capacitor Cst may include a first electrode CE1 and a second electrode CE2. The first electrode CE1 of the storage capacitor Cst may be electrically connected to the gate electrode of the first transistor T1, and the second electrode CE2 of the storage capacitor Cst may be electrically connected to the eighth transistor line T8 and the ninth transistor T9.

The auxiliary capacitor Ca may be electrically connected to the sixth transistor T6, the sustain voltage line VSL, and the first electrode of the light-emitting element LED. The auxiliary capacitor Ca may store and maintain a voltage corresponding to a voltage difference between the first electrode of the light-emitting element LED and the sustain voltage line VSL while the seventh transistor T7 and the ninth transistor T9 are turned on, and thus, the problem that increases black luminance when the sixth transistor T6 is turned off may be prevented.

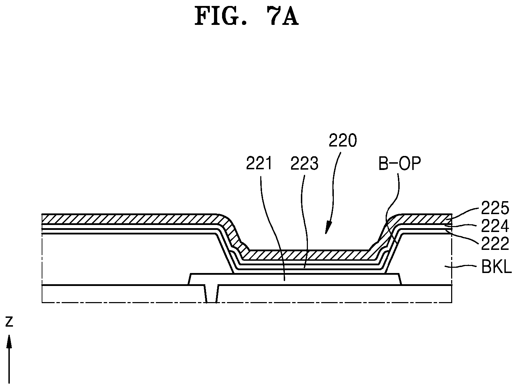

FIG. 7A is a cross-sectional view schematically illustrating a light-emitting element of a stretchable display device, according to an embodiment.

Referring to FIG. 7A, the light-emitting element according to an embodiment may include an organic light-emitting diode 220 including an organic material. The organic light-emitting diode 220 may include a first electrode 221 disposed on an insulating layer, a second electrode 225 facing the first electrode 221, and an emission layer 223 between the first electrode 221 and the second electrode 225. A first functional layer 222 may be between the first electrode 221 and the emission layer 223, and a second functional layer 224 may be between the emission layer 223 and the second electrode 225.

The edge of the first electrode 221 may be covered with a bank layer BKL including an insulating material. The bank layer BKL may include an opening B-OP overlapping the central portion of the first electrode 221 in a plan view.

The first electrode 221 may include a conductive oxide, such as indium tin oxide ("ITO"), indium zinc oxide IZO, zinc oxide (ZnO), indium oxide (In₂O₃), indium gallium oxide ("IGO"), or aluminum zinc oxide ("AZO"). In another embodiment, the first electrode 221 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or any compound thereof. In another embodiment, the first electrode 221 may further include a layer including ITO, IZO, ZnO, AZO, or In₂O₃ above and/or below the reflective layer.

The emission layer 223 may include a high molecular weight organic material or a low molecular weight organic material that emits light of a certain color. The first functional layer 222 may include a hole transport layer ("HTL") and/or a hole injection layer ("HIL"). The second functional layer 224 may include an electron transport layer ("ETL") and/or an electron injection layer ("EIL").

The second electrode 225 may include a conductive material having a low work function. For example, the second electrode 225 may include a (semi)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or any alloy thereof. Alternatively, the second electrode 225 may further include a layer including ITO, IZO, ZnO, AZO, or In₂O₃ on the (semi)transparent layer including the material described above.

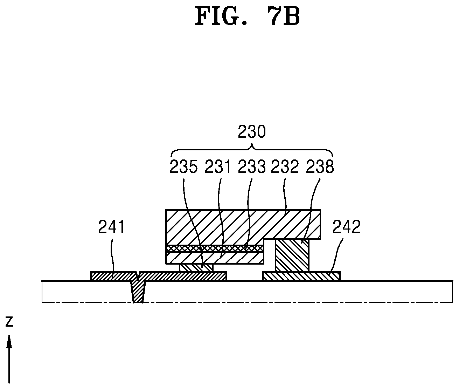

FIG. 7B is a cross-sectional view schematically illustrating a light-emitting element of a stretchable display device, according to an embodiment.

Referring to FIG. 7B, the light-emitting element according to an embodiment may include an inorganic light-emitting diode 230 including an inorganic material. The inorganic light-emitting diode 230 may include a first semiconductor layer 231, a second semiconductor layer 232, an intermediate layer 233 between the first semiconductor layer 231 and the second semiconductor layer 232, a first electrode 235 electrically connected to the first semiconductor layer 231, and a second electrode 238 electrically connected to the second semiconductor layer 232. The first electrode 235 and the second electrode 238 of the inorganic light-emitting diode 230 may be electrically connected to a first electrode pad 241 and a second electrode pad 242, respectively, which are arranged in the same layer.

In some embodiments, the first semiconductor layer 231 may include a p-type semiconductor layer. The p-type semiconductor layer may be selected from semiconductor materials having a composition formula of InₓAl_{y}Ga_{1-x-y}N (0≤x≤1, 0≤y≤1, 0≤x+y≤1), for example, GaN, AIN, AlGaN, InGaN, InN, InAlGaN, or AlInN, and may be doped with a p-type dopant, such as Mg, Zn, Ca, Sr, or Ba.

The second semiconductor layer 232 may include, for example, an n-type semiconductor layer. The n-type semiconductor layer may be selected from semiconductor materials having a composition formula of InₓAl_{y}Ga_{1-x-y}N (0≤x≤1, 0≤y≤1, 0≤x+y≤1), for example, GaN, AIN, AlGaN, InGaN, InN, InAlGaN, or AlInN, and may be doped with an n-type dopant, such as Si, Ge, or Sn.

The intermediate layer 233 is an area in which electrons and holes recombine. As the electrons and the holes recombine, the intermediate layer 233 may transition to a low energy level to generate light having a wavelength corresponding thereto. For example, the intermediate layer 233 may include a semiconductor material having a composition formula of InₓAl_{y}Ga_{1-x-y}N (0≤x≤1, 0≤y≤1, 0≤x+y≤1), and may have a single quantum well structure or a multi quantum well ("MQW") structure. In addition, the intermediate layer 233 may have a quantum wire structure or a quantum dot structure.

Although FIG. 7B illustrates that the first semiconductor layer 231 includes a p-type semiconductor layer and the second semiconductor layer 232 includes an n-type semiconductor layer, the disclosure is not limited thereto. In another embodiment, the first semiconductor layer 231 may include an n-type semiconductor layer and the second semiconductor layer 232 may include a p-type semiconductor layer.

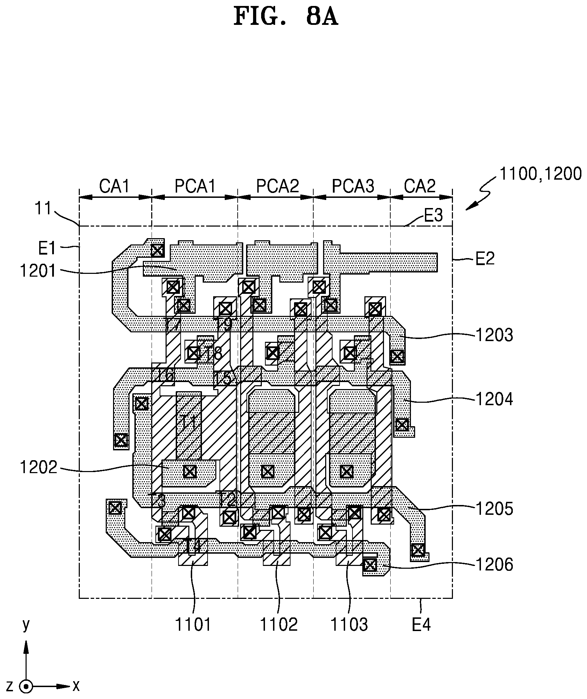

FIGS. 8A to 8F are layer-by-layer layout diagrams schematically illustrating a main island portion of a stretchable display device, according to an embodiment.

As described with reference to FIGS. 4A to 4C, the stretchable display device 1 may include a main island portion 11 disposed in a display area DA and a plurality of main bridge portions 12 connected to the main island portion 11. The main island portion 11 may include a plurality of sub-pixels, and the main bridge portion 12 may include lines electrically connected to the sub-pixels.

The main island portion 11 may have a first boundary E1 and a second boundary E2 each extending in the second direction (e.g., the +y direction and/or the -y direction) and arranged on opposite sides of the main island portion 11, respectively, and a third boundary E3 and a fourth boundary E4 each extending in the first direction (e.g., the +x direction and/or the -x direction) and connecting the first boundary E1 to the second boundary E2.

In an embodiment, a first sub-pixel, a second sub-pixel, and a third sub-pixel that are configured to emit pieces of light of different colors may be arranged in the main island portion 11. The first sub-pixel may include a first light-emitting element and a first pixel driving circuit connected to the first light-emitting element, the second sub-pixel may include a second light-emitting element and a second pixel driving circuit connected to the second light-emitting element, and the third sub-pixel may include a third light-emitting element and a third pixel driving circuit connected to the third light-emitting element. The disclosure is not limited thereto, and one sub-pixel, two sub-pixels, or four sub-pixels may be arranged in the main island portion 11.

The first pixel driving circuit may be arranged in a first circuit area PCA1, the second pixel driving circuit may be arranged in a second circuit area PCA2, and the third pixel driving circuit may be arranged in a third circuit area PCA3. The first circuit area PCA1, the second circuit area PCA2, and the third circuit area PCA3 may be arranged side-by-side in the first direction (e.g., the +x direction and/or the -x direction). A first connection area CA1 may be between the first boundary E1 of the main island portion 11 and the first circuit area PCA1, and a second connection area CA2 may be between the second boundary E2 of the main island portion 11 and the third circuit area PCA3. Lines extending from the main bridge portions 12 to the main island portion 11 may be arranged in the first connection area CA1 and the second connection area CA2.

The first pixel driving circuit, the second pixel driving circuit, and the third pixel driving circuit may have substantially the same or similar structures. Hereinafter, the respective configurations will be described focusing on the first pixel driving circuit arranged in the first circuit area PCA1, and the description of the same or similar configurations arranged in the second circuit area PCA2 and the third circuit area PCA3 will be omitted.

The main island portion 11 may include a semiconductor layer 1100, a first conductive layer 1200, a second conductive layer 1300, a third conductive layer 1400, a fourth conductive layer 1500, a fifth conductive layer 1600, and a sixth conductive layer 1700, which are sequentially stacked on the substrate (see 100 of FIG. 5) in this stated order. The semiconductor layer 1100, the first conductive layer 1200, the second conductive layer 1300, the third conductive layer 1400, the fourth conductive layer 1500, the fifth conductive layer 1600, and the sixth conductive layer 1700 may form signal lines and voltage lines connected to the pixel driving circuits (see PC of FIG. 6C) and transistors and capacitors connected to the pixel driving circuits (see PC of FIG. 6C).

FIG. 8A illustrates the semiconductor layer 1100 and the first conductive layer 1200 disposed on the semiconductor layer 1100. The semiconductor layer 1100 may be disposed on the substrate (see 100 of FIG. 5), and the buffer layer (see 111 of FIG. 5) may be between the semiconductor layer 1100 and the substrate (see 100 of FIG. 5). One or more insulating layers (e.g., the first gate insulating layer) may be between the semiconductor layer 1100 and the first conductive layer 1200.

Referring to FIG. 8A, the semiconductor layer 1100 may include a first semiconductor pattern 1101, a second semiconductor pattern 1102, and a third semiconductor pattern 1103. The first pixel driving circuit may include the first semiconductor pattern 1101, the second pixel driving circuit may include the second semiconductor pattern 1102, and the third pixel driving circuit may include the third semiconductor pattern 1103.

The first semiconductor pattern 1101 may be arranged in a first circuit area PCA1, the second semiconductor pattern 1102 may be arranged in a second circuit area PCA2, and the third semiconductor pattern 1103 may be arranged in a third circuit area PCA3.

In an embodiment, the semiconductor layer 1100 may include a silicon-based semiconductor material, for example, polysilicon. In another embodiment, the semiconductor layer 1100 may include an oxide-based semiconductor material, for example, an oxide of at least one selected from indium (In), gallium (Ga), stannum (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn).

The first conductive layer 1200 may include first conductive patterns 1201, second conductive patterns 1202, third conductive patterns 1203, fourth conductive patterns 1204, fifth conductive patterns 1205, and sixth conductive patterns 1206. The first conductive layer 1200 may include a conductive material including molybdenum (Mo), aluminum (Al), copper (Cu), titanium (Ti), and the like, and may include a single layer or layers including the conductive material described above.

The first conductive patterns 1201 may be arranged in the first circuit area PCA1, the second circuit area PCA2, and the third circuit area PCA3. The first conductive pattern 1201 arranged in the first circuit area PCA1 may extend to the first connection area CA1. The first conductive pattern 1201 arranged in the third circuit area PCA3 may extend to the second connection area CA2. The first conductive patterns 1201 may be arranged adjacent to the third boundary E3 of the main island portion 11. The first conductive patterns 1201 may function as the first electrode (lower electrode) of the auxiliary capacitor (see Ca of FIG. 6C).

The second conductive patterns 1202 may be arranged in the first circuit area PCA1, the second circuit area PCA2, and the third circuit area PCA3. The second conductive patterns 1202 may overlap the first semiconductor pattern 1101, the second semiconductor pattern 1102, or the third semiconductor pattern 1103, respectively, in a plan view to form the first transistors T1. The second conductive patterns 1202 may each include the gate electrode of the first transistor T1. That is, a portion of the first semiconductor pattern 1101 overlapping the second conductive pattern 1202 in a plan view may be the channel region of the first transistor T1, and impurity regions functioning as the first or second terminals may extend to opposite sides of the channel region of the first transistor T1.

In an embodiment, the width of the first semiconductor pattern 1101, which functions as the channel region of the first transistor T1, in the second direction (e.g., the +y direction and/or the -y direction) may be greater than the width of the second semiconductor pattern 1102 and the third semiconductor pattern 1103, which function as the channel region of the first transistor T1, in the second direction (e.g., the +y direction and/or the -y direction). In an embodiment, the width of the second conductive pattern 1202, which is arranged in the first circuit area PCA1, in the first direction (e.g., the +x direction and/or the -x direction) may be less than the width of the second conductive pattern 1202, which is arranged in the second circuit area PCA2 and the third circuit area PCA3, in the first direction (e.g., the +x direction and/or the -x direction).

The third conductive pattern 1203 may extend from the first connection area CA1 to the second connection area CA2 across the first circuit area PCA1, the second circuit area PCA2, and the third circuit area PCA3. The third conductive pattern 1203 may overlap the first semiconductor pattern 1101, the second semiconductor pattern 1102, and the third semiconductor pattern 1103 in a plan view. The third conductive pattern 1203 may overlap the first semiconductor pattern 1101, the second semiconductor pattern 1102, and the third semiconductor pattern 1103 in a plan view to form the seventh transistors T7 and the ninth transistors T9. The third conductive pattern 1203 may include a gate electrode of the seventh transistor T7 and a gate electrode of the ninth transistor T9.

The fourth conductive pattern 1204 may extend from the first connection area CA1 to the second connection area CA2 across the first circuit area PCA1, the second circuit area PCA2, and the third circuit area PCA3. The fourth conductive pattern 1204 may overlap the first semiconductor pattern 1101, the second semiconductor pattern 1102, and the third semiconductor pattern 1103 in a plan view to form the fifth transistors T5, the sixth transistors T6, and the eighth transistors T8. That is, the fourth conductive pattern 1204 may include a gate electrode of the fifth transistor T5, a gate electrode of the sixth transistor T6, and a gate electrode of the eighth transistor T8.

The fifth conductive pattern 1205 may extend from the first connection area CA1 to the second connection area CA2 across the first circuit area PCA1, the second circuit area PCA2, and the third circuit area PCA3. The fifth conductive pattern 1205 may overlap the first semiconductor pattern 1101, the second semiconductor pattern 1102, and the third semiconductor pattern 1103 in a plan view to form the second transistors T2 and the third transistors T3. The fifth conductive pattern 1205 may include a gate electrode of the second transistor T2 and a gate electrode of the third transistor T3.

The sixth conductive pattern 1206 may extend from the first connection area CA1 to the third circuit area PCA3 across the first circuit area PCA1 and the second circuit area PCA2. The sixth conductive patterns 1206 may overlap the first semiconductor pattern 1101, the second semiconductor pattern 1102, and the third semiconductor pattern 1103 in a plan view to form the fourth transistors T4. The sixth conductive patterns 1206 may include a gate electrode of the fourth transistor T4.

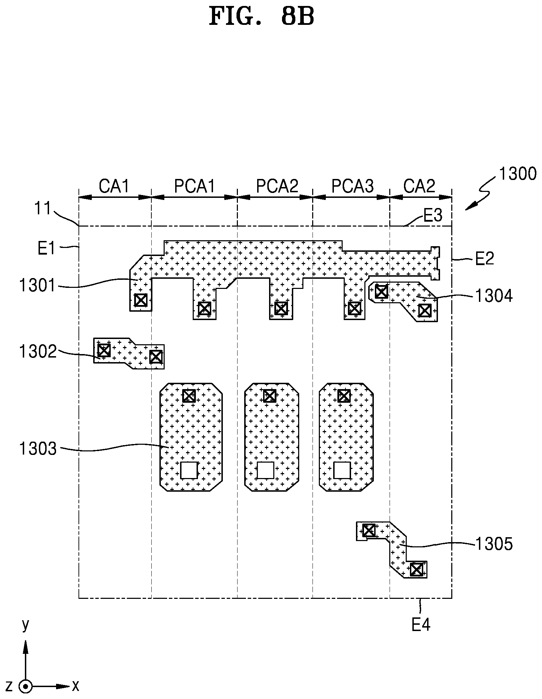

Referring to FIG. 8B, the second conductive layer 1300 may include a seventh conductive pattern 1301, an eighth conductive pattern 1302, a ninth conductive pattern 1303, a tenth conductive pattern 1304, and an eleventh conductive pattern 1305. The second conductive layer 1300 may be disposed on the first conductive layer 1200, and one or more insulating layers (e.g., the second gate insulating layer) may be between the first conductive layer 1200 and the second conductive layer 1300. The second conductive layer 1300 may include a conductive material including molybdenum (Mo), aluminum (Al), copper (Cu), titanium (Ti), and the like, and may include a single layer or layers including the conductive material described above.

The seventh conductive pattern 1301 may extend from the first connection area CA1 to the second connection area CA2 across the first circuit area PCA1, the second circuit area PCA2, and the third circuit area PCA3. The seventh conductive pattern 1301 may be disposed to overlap the first conductive pattern 1201 in a plan view and may function as the second electrode (upper electrode) of the auxiliary capacitor (see Ca of FIG. 6C).

The eighth conductive pattern 1302 may be arranged in the first connection area CA1 and the first circuit area PCA1. The eighth conductive pattern 1302 may be a connection electrode for connecting the sustain voltage line VSL and the seventh conductive pattern 1301.

The ninth conductive patterns 1303 may be arranged in the first circuit area PCA1, the second circuit area PCA2, and the third circuit area PCA3. The ninth conductive pattern 1303 may be disposed to overlap the second conductive pattern 1202 of the first conductive layer 1200 in a plan view, and may define an opening exposing a portion of the second conductive pattern 1202. The ninth conductive pattern 1303 may function as the second electrode (see CE2 of FIG. 6C) of the storage capacitor (see Cst of FIG. 6C), and the second conductive pattern 1202 overlapping the ninth conductive pattern 1303 in a plan view may function as the first electrode (see CE1 of FIG. 6C) of the storage capacitor Cst.

The tenth conductive pattern 1304 may be arranged in the third circuit area PCA3 and the second connection area CA2. The tenth conductive pattern 1304 may be a connection electrode for connecting a 2^{nd}-1 initialization voltage line VIL2a to a 2^{nd}-2 initialization voltage line VIL2b.

The eleventh conductive pattern 1305 may be arranged in the third circuit area PCA3 and the second connection area CA2. The eleventh conductive pattern 1305 may be a connection electrode for connecting a 1^{st}-1 initialization voltage line VIL1a to a 1^{st}-2 initialization voltage line VIL1b.

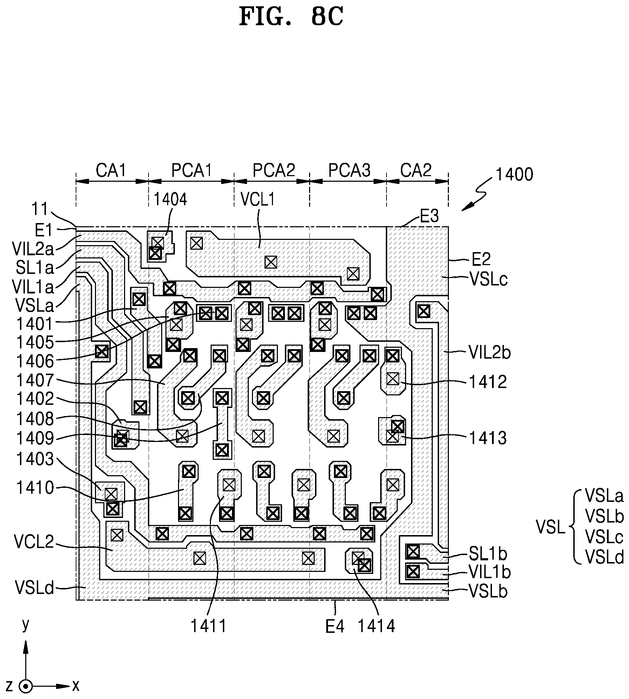

Referring to FIG. 8C, the third conductive layer 1400 may include twelfth to twenty-fifth conductive patterns 1401 to 1414, a first voltage connection line VCL1, and a second voltage connection line VCL2. The third conductive layer 1400 may further include the wirings (see WL of FIG. 5) extending from the main island portion 11 to the main bridge portions. The third conductive layer 1400 may be disposed on the second conductive layer 1300, and one or more insulating layers (e.g., the interlayer-insulating layer) may be between the second conductive layer 1300 and the third conductive layer 1400.

The third conductive layer 1400 may include a stretchable conductive material. The third conductive layer 1400 may include a conductive material including molybdenum (Mo), aluminum (Al), copper (Cu), titanium (Ti), and the like, and may include a single layer or layers including the conductive material described above. For example, the third conductive layer 1400 may include a multilayer of Ti/Al/Ti.

The twelfth conductive pattern 1401 may be arranged in the first connection area CA1 and the first circuit area PCA1. The twelfth conductive pattern 1401 may be connected to the seventh conductive pattern 1301 and the eighth conductive pattern 1302 of the second conductive layer 1300 through contact holes.

A thirteenth conductive pattern 1402 may be arranged in the first connection area CA1, and a twenty-fourth conductive pattern 1413 may be arranged in the second connection area CA2. The thirteenth conductive pattern 1402 and the twenty-fourth conductive pattern 1413 may be connected to the fourth conductive pattern 1204 of the first conductive layer 1200 through contact holes. The thirteenth conductive pattern 1402 may be connected to the first emission control line EMLa of the fourth conductive layer 1500 through a contact hole, and the twenty-fourth conductive pattern 1413 may be connected to the second emission control line EMLb of the fourth conductive layer 1500 through a contact hole.

A fourteenth conductive pattern 1403 may be arranged in the first connection area CA1, and a twenty-fifth conductive pattern 1414 may be arranged in the third circuit area PCA3. The fourteenth conductive pattern 1403 and the twenty-fifth conductive pattern 1414 may be connected to the sixth conductive pattern 1206 of the first conductive layer 1200 through contact holes. The fourteenth conductive pattern 1403 may be connected to the 3^{rd}-1 scan line SL3a of the fourth conductive layer 1500 through a contact hole, and the twenty-fifth conductive pattern 1414 may be connected to the 3^{rd}-2 scan line SL3b of the fourth conductive layer 1500 through a contact hole.

A fifteenth conductive pattern 1404 may be arranged in the first circuit area PCA1, and a twenty-third conductive pattern 1412 may be arranged in the second connection area CA2. The fifteenth conductive pattern 1404 and the twenty-third conductive pattern 1412 may be connected to the third conductive pattern 1203 of the first conductive layer 1200 through contact holes. The fifteenth conductive pattern 1404 may be connected to the 2^{nd}-1 scan line SL2a of the fourth conductive layer 1500 through a contact hole, and the twenty-third conductive pattern 1412 may be connected to the 2^{nd}-2 scan line SL2b of the fourth conductive layer 1500 through a contact hole.

Sixteenth conductive patterns 1405 may be arranged in the first circuit area PCA1, the second circuit area PCA2, and the third circuit area PCA3. The sixteenth conductive patterns 1405 may be connected to the first semiconductor pattern 1101, the second semiconductor pattern 1102, or the third semiconductor pattern 1103 of the semiconductor layer 1100 through contact holes. The sixteenth conductive patterns 1405 may be connected to the first conductive pattern 1201 of the first conductive layer 1200 and a twenty-sixth conductive pattern 1501 of the fourth conductive layer 1500 through contact holes. The sixteenth conductive pattern 1405 may connect the sixth transistor T6, the seventh transistor T7, the first electrode pad 241 of the light-emitting element (see LED of FIG. 6C), and the auxiliary capacitor (see Ca of FIG. 6C).

Seventeenth conductive patterns 1406 may be arranged in the first circuit area PCA1, the second circuit area PCA2, and the third circuit area PCA3. The seventeenth conductive patterns 1406 may be connected to the first semiconductor pattern 1101, the second semiconductor pattern 1102, or the third semiconductor pattern 1103 of the semiconductor layer 1100 through contact holes. The seventeenth conductive patterns 1406 may each be connected to the seventh conductive pattern 1301 of the second conductive layer 1300 through contact holes. The seventeenth conductive pattern 1406 may be configured to transmit the sustain voltage (see VSUS of FIG. 6C) to the ninth transistor T9.

Eighteenth conductive patterns 1407 may be arranged in the first circuit area PCA1, the second circuit area PCA2, and the third circuit area PCA3. The eighteenth conductive patterns 1407 may be connected to the first semiconductor pattern 1101, the second semiconductor pattern 1102, or the third semiconductor pattern 1103 of the semiconductor layer 1100 through contact holes. The eighteenth conductive patterns 1407 may each be connected to the third voltage connection line VCL3 of the fourth conductive layer 1500 through contact holes. The eighteenth conductive patterns 1407 may be configured to transmit the driving power supply voltage (see VDD of FIG. 6C) to the eighth transistor T8.

Nineteenth conductive patterns 1408 may be arranged in the first circuit area PCA1, the second circuit area PCA2, and the third circuit area PCA3. The nineteenth conductive patterns 1408 may be connected to the first semiconductor pattern 1101, the second semiconductor pattern 1102, or the third semiconductor pattern 1103 of the semiconductor layer 1100 through contact holes. The nineteenth conductive patterns 1408 may each be connected to the ninth conductive pattern 1303 of the second conductive layer 1300 through contact holes. The nineteenth conductive pattern 1408 may connect the eighth transistor T8 to the second electrode (see CE2 of FIG. 6C) of the storage capacitor (see Cst of FIG. 6C).

Twentieth conductive pattern 1409 may be arranged in the first circuit area PCA1. The twentieth conductive patterns 1409 may each be connected to the first semiconductor pattern 1101 of the semiconductor layer 1100 through contact holes. The twentieth conductive pattern 1409 may connect the second transistor T2 to the fifth transistor T5 of the first pixel driving circuit.

Twenty-first conductive patterns 1410 may be arranged in the first circuit area PCA1, the second circuit area PCA2, and the third circuit area PCA3. The twenty-first conductive patterns 1410 may be connected to the first semiconductor pattern 1101, the second semiconductor pattern 1102, and the third semiconductor pattern 1103 of the semiconductor layer 1100 through contact holes. The twenty-first conductive patterns 1410 may each be connected to the second conductive pattern 1202 of the first conductive layer 1200 through contact holes. The twenty-first conductive pattern 1410 may connect the third transistor T3, the fourth transistor T4, and the first electrode (see CE1 of FIG. 6C) of the storage capacitor (see Cst of FIG. 6C) to each other.

Twenty-second conductive patterns 1411 may be arranged in the first circuit area PCA1, the second circuit area PCA2, and the third circuit area PCA3. For example, the twenty-second conductive pattern 1411 arranged in the first circuit area PCA1 may be connected to the first semiconductor pattern 1101 of the semiconductor layer 1100 and the first data line DL1 of the fourth conductive layer 1500 through contact holes. Similarly, the twenty-second conductive pattern 1411 arranged in the second circuit area PCA2 may be connected to the second semiconductor pattern 1102 of the semiconductor layer 1100 and the second data line DL2 of the fourth conductive layer 1500 through contact holes, and the twenty-second conductive pattern 1411 arranged in the third circuit area PCA3 may be connected to the third semiconductor pattern 1103 of the semiconductor layer 1100 and the third data line DL3 of the fourth conductive layer 1500 through the contact holes. The twenty-second conductive pattern 1411 may connect the second transistor T2 to the data line DL.

The first voltage connection line VCL1 may extend from the first circuit area PCA1 to the third circuit area PCA3 across the second circuit area PCA2. The first voltage connection line VCL1 may be connected to the third voltage connection lines VCL3 of the fourth conductive layer 1500 through contact holes.

The second voltage connection line VCL2 may extend from the first connection area CA1 to the third circuit area PCA3 across the first circuit area PCA1 and the second circuit area PCA2. The second voltage connection line VCL2 may be connected to the third voltage connection lines VCL3 of the fourth conductive layer 1500 through contact holes.

The main bridge portions may include a first bridge portion extending from the first boundary E1 of the main island portion 11, a second bridge portion extending from the second boundary E2, a third bridge portion extending from the third boundary E3, and a fourth bridge portion extending from the fourth boundary E4.

The third conductive layer 1400 may include a 1^{st}-1 initialization voltage line VIL1a extending from the main island portion 11 to the first bridge portion, a 2^{nd}-1 initialization voltage line VIL2a, a 1^{st}-1 scan line SL1a, and a first sustain voltage line VSLa. The third conductive layer 1400 may include a 1^{st}-2 initialization voltage line VIL1b extending from the main island portion 11 to the second bridge portion, a 2^{nd}-2 initialization voltage line VIL2b, a 1^{st}-2 scan line SL1b, and a second sustain voltage line VSLb. In addition, the third conductive layer 1400 may include a third sustain voltage line VSLc extending from the main island portion 11 to the third bridge portion and a fourth sustain voltage line VSLd extending from the main island portion 11 to the fourth bridge portion.

The sustain voltage line VSL configured to transmit the sustain voltage (see VSUS of FIG. 6C) may include a first sustain voltage line VSLa, a second sustain voltage line VSLb, a third sustain voltage line VSLc, and a fourth sustain voltage line VSLd. The first sustain voltage line VSLa, the second sustain voltage line VSLb, the third sustain voltage line VSLc, and the fourth sustain voltage line VSLd may extend along the first boundary E1, the second boundary E2, and the fourth boundary E4 of the main island portion 11 and may be connected to each other.

The first sustain voltage line VSLa and the second sustain voltage line VSLb connecting the main island portions 11 adjacent to each other in the first direction (e.g., the +x direction and/or the -x direction) and the third sustain voltage line VSLc and the fourth sustain voltage line VSLd connecting the main island portions 11 adjacent to each other in the second direction (e.g., the +y direction and/or the -y direction) may be connected to each other in the main island portion 11. The first sustain voltage line VSLa, the second sustain voltage line VSLb, the third sustain voltage line VSLc, and the fourth sustain voltage line VSLd may be integrally formed as a single body in the third conductive layer 1400. Accordingly, the sustain voltage line VSL may have a mesh structure in the display area (see DA of FIG. 1) of the stretchable display device (see 1 of FIG. 1).

The first sustain voltage line VSLa may be connected to the eighth conductive pattern 1302 of the second conductive layer 1300 through a contact hole. The eighth conductive pattern 1302 may be connected to the twelfth conductive pattern 1401 of the third conductive layer 1400, and the twelfth conductive pattern 1401 may be connected to the seventh conductive pattern 1301 of the second conductive layer 1300. The seventh conductive pattern 1301 may be connected to the first semiconductor pattern 1101 and the second semiconductor pattern 1102 of the semiconductor layer 1100 through the seventeenth conductive patterns 1406. The third sustain voltage line VSLc may be connected to the third semiconductor pattern 1103 of the semiconductor layer 1100 and the seventh conductive pattern 1301 of the second conductive layer 1300 through contact holes.

The first initialization voltage line (see VIL1 of FIG. 6C) configured to transmit the first initialization voltage (see Vint of FIG. 6C) may include a 1^{st}-1 initialization voltage line VIL1a and a 1^{st}-2 initialization voltage line VIL1b connecting the main island portions 11 adjacent to each other in the first direction (e.g., the +x direction and/or the -x direction). The 1^{st}-1 initialization voltage line VIL1a may extend approximately parallel to the first boundary E1 in the first connection area CA1, and may extend from the first connection area CA1 to the third circuit area PCA3 across the first circuit area PCA1 and the second circuit area PCA2. The 1^{st}-1 initialization voltage line VIL1a may be connected to the first semiconductor pattern 1101, the second semiconductor pattern 1102, and the third semiconductor pattern 1103 of the semiconductor layer 1100 through contact holes. The 1^{st}-1 initialization voltage line VIL1a and the 1^{st}-2 initialization voltage line VIL1b may be connected to each other in the main island portion 11 through the eleventh conductive pattern 1305 of the second conductive layer 1300.

The second initialization voltage line (see VIL2 of FIG. 6C) configured to transmit the second initialization voltage (see Vaint of FIG. 6C) may include a 2^{nd}-1 initialization voltage line VIL2a and a 2^{nd}-2 initialization voltage line VIL2b connecting the main island portions 11 adjacent to each other in the first direction (e.g., the +x direction and/or the - x direction). The 2^{nd}-1 initialization voltage line VIL2a may extend from the first connection area CA1 to the third circuit area PCA3 across the first circuit area PCA1 and the second circuit area PCA2. The 2^{nd}-2 initialization voltage line VIL2b may extend from the second connection area CA2 along the second boundary E2. The 2^{nd}-1 initialization voltage line VIL2a may be connected to the first semiconductor pattern 1101, the second semiconductor pattern 1102, and the third semiconductor pattern 1103 through contact holes. The 2^{nd}-1 initialization voltage line VIL2a and the 2^{nd}-2 initialization voltage line VIL2b may be connected to each other in the main island portion 11 through the tenth conductive pattern 1304 of the second conductive layer 1300.

The first scan line (see SL1 of FIG. 6C) configured to transmit the first scan signal (see GW of FIG. 6C) may include a 1^{st}-1 scan line SL1a and a 1^{st}-2 scan line SL1b connecting the main island portions 11 adjacent to each other in the first direction (e.g., the +x direction and/or the -x direction). The 1^{st}-1 scan line SL1a may extend substantially parallel to the first boundary E1 in the first connection area CA1. The 1^{st}-2 scan line SL1b may be arranged in the second connection area CA2, and the 1^{st}-1 scan line SL1a and the 1^{st}-2 scan line SL1b may be connected to each other through the fifth conductive pattern 1205 of the first conductive layer 1200.

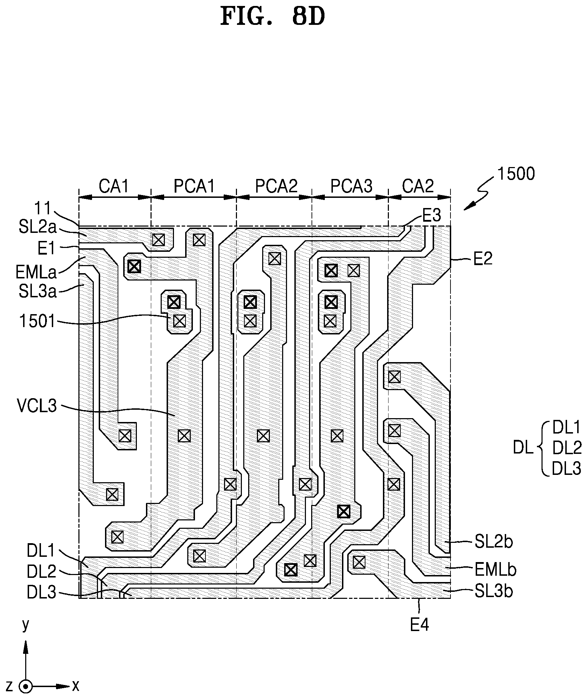

Referring to FIG. 8D, the fourth conductive layer 1500 may include a twenty-sixth conductive pattern 1501 and third voltage connection lines VCL3. In addition, the fourth conductive layer 1500 may further include the wirings (see WL of FIG. 5) extending from the main island portion 11 to the main bridge portions. The fourth conductive layer 1500 may be disposed on the third conductive layer 1400, and one or more organic insulating layers (e.g., the first organic insulating layer) may be between the third conductive layer 1400 and the fourth conductive layer 1500.

The fourth conductive layer 1500 may include a stretchable conductive material. The fourth conductive layer 1500 may include a conductive material including molybdenum (Mo), aluminum (Al), copper (Cu), titanium (Ti), and the like, and may include a single layer or layers including the conductive material described above. For example, the fourth conductive layer 1500 may include a multilayer of Ti/Al/Ti.

The twenty-sixth conductive patterns 1501 may be arranged in the first circuit area PCA1, the second circuit area PCA2, and the third circuit area PCA3. The twenty-sixth conductive patterns 1501 may be connected to the sixteenth conductive pattern 1405 of the third conductive layer 1400 and a twenty-seventh conductive pattern 1601 of the fifth conductive layer 1600 through contact holes. The twenty-sixth conductive pattern 1501 may connect the sixth transistor T6, the seventh transistor T7, the first electrode of the light-emitting element (see LED of FIG. 6C), and the auxiliary capacitor (see Ca of FIG. 6C).

Each of the third voltage connection lines VCL3 may be connected to the first pixel driving circuit, the second pixel driving circuit, or the third pixel driving circuit. The third voltage connection line VCL3 of the first pixel driving circuit may extend from the first circuit area PCA1 to the first connection area CA1, the third voltage connection line VCL3 of the second pixel driving circuit may extend from the second circuit area PCA2 to the first circuit area PCA1, and the third voltage connection line VCL3 of the third pixel driving circuit may extend from the third circuit area PCA3 to the second circuit area PCA2. Each of the third voltage connection lines VCL3 may be connected to the eighteenth conductive pattern 1407, the first voltage connection line VCL1, and the second voltage connection line VCL2 of the third conductive layer 1400 through contact holes.

The third voltage connection line VCL3 of the first pixel driving circuit may be connected to the first driving voltage line VDDLa of the fifth conductive layer 1600 through a contact hole. The third voltage connection line VCL3 of the third pixel driving circuit may be connected to the second driving voltage line VDDLb, the third driving voltage line VDDLc, and the fourth driving voltage line VDDLd of the fifth conductive layer 1600 through contact holes. The first to fourth driving voltage line VDDLa to VDDLd may be connected to each other through the first voltage connection line VCL1, the second voltage connection line VCL2, and the third voltage connection line VCL3 in the main island portion 11. Accordingly, the driving voltage line VDDL including the first to fourth driving voltage lines VDDLa to VDDLd may have a mesh structure in the display area (see DA of FIG. 1) of the stretchable display device.

The fourth conductive layer 1500 may include a 2^{nd}-1 scan line SL2a, a first emission control line EMLa, and a 3^{rd}-1 scan line SL3a each extending from the main island portion 11 to the first bridge portion. The fourth conductive layer 1500 may include a 2^{nd}-2 scan line SL2b, a second emission control line EMLb, and a 3^{rd}-2 scan line SL3b each extending from the main island portion 11 to the second bridge portion. The fourth conductive layer 1500 may include data lines DL extending from the third bridge portion to the fourth bridge portion across the main island portion 11.

The second scan line (see SL2 of FIG. 6C) configured to transmit the second scan signal (see GB of FIG. 6C) may include a 2^{nd}-1 scan line SL2a and a 2^{nd}-2 scan line SL2b connecting the main island portions 11 adjacent to each other in the first direction (e.g., the +x direction and/or the -x direction). The 2^{nd}-1 scan line SL2a may extend from the first connection area CA1 to the first circuit area PCA1 along the third boundary E3, and the 2^{nd}-2 scan line SL2b may extend from the second connection area CA2 along the second boundary E2. The 2^{nd}-1 scan line SL2a and the 2^{nd}-2 scan line SL2b may be connected to each other through the fifteenth conductive pattern 1404 of the third conductive layer 1400, the third conductive pattern 1203 of the first conductive layer 1200, and the twenty-third conductive pattern 1412 of the third conductive layer 1400 in the main island portion 11.

The emission control line (see EML of FIG. 6C) configured to transmit the emission control signal (see EM of FIG. 6C) may include a first emission control line EMLa and a second emission control line EMLb connecting the main island portions 11 adjacent to each other in the first direction (e.g., the +x direction and/or the -x direction). The first emission control line EMLa may extend substantially parallel to the first boundary E1 in the first connection area CA1, and the second emission control line EMLb may extend substantially parallel to the second boundary E2 in the second connection area CA2. The first emission control line EMLa and the second emission control line EMLb may be connected to each other through the thirteenth conductive pattern 1402 of the third conductive layer 1400, the fourth conductive pattern 1204 of the first conductive layer 1200, and the twenty-fourth conductive pattern 1413 of the third conductive layer 1400 in the main island portion 11.

The third scan line (see SL3 of FIG. 6C) configured to transmit the third scan signal (see GI of FIG. 6C) may include a 3^{rd}-1 scan line SL3a and a 3^{rd}-2 scan line SL3b connecting the main island portions 11 adjacent to each other in the first direction (e.g., the +x direction and/or the -x direction). The 3^{rd}-1 scan line SL3a may extend from the first connection area CA1 along the first boundary E1, and the 3^{rd}-2 scan line SL3b may extend from the second connection area CA2 to the third circuit area PCA3 along the fourth boundary E4. The 3^{rd}-1 scan line SL3a and the 3^{rd}-2 scan line SL3b may be connected to each other through the fourteenth conductive pattern 1403 of the third conductive layer 1400, the sixth conductive pattern 1206 of the first conductive layer 1200, and the twenty-fifth conductive pattern 1414 of the third conductive layer 1400 in the main island portion 11.

The data lines DL may include a first data line DL1 connected to the first pixel driving circuit, a second data line DL2 connected to the second pixel driving circuit, and a third data line DL3 connected to the third pixel driving circuit.

The first data line DL1, the second data line DL2, and the third data line DL3 may extend from the first connection area CA1 to the second connection area CA2 across the first circuit area PCA1, the second circuit area PCA2, and the third circuit area PCA3. At this time, the first data line DL1 may cross the first circuit area PCA1 approximately in the second direction (e.g., the +y direction and/or the -y direction), the second data line DL2 may cross the second circuit area PCA2 approximately in the second direction (e.g., the +y direction and/or the -y direction), and the third data line DL3 may cross the third circuit area PCA3 approximately in the second direction (e.g., the +y direction and/or the -y direction). Each of the first data line DL1, the second data line DL2, and the third data line DL3 may be connected to the first semiconductor pattern 1101, the second semiconductor pattern 1102, or the third semiconductor pattern 1103 of the semiconductor layer 1100 through the twenty-second conductive pattern 1411. Each of the first data line DL1, the second data line DL2, and the third data line DL3 may be configured to transmit the data signal (see Dm of FIG. 6C) to the second transistor T2 of the corresponding pixel driving circuit.

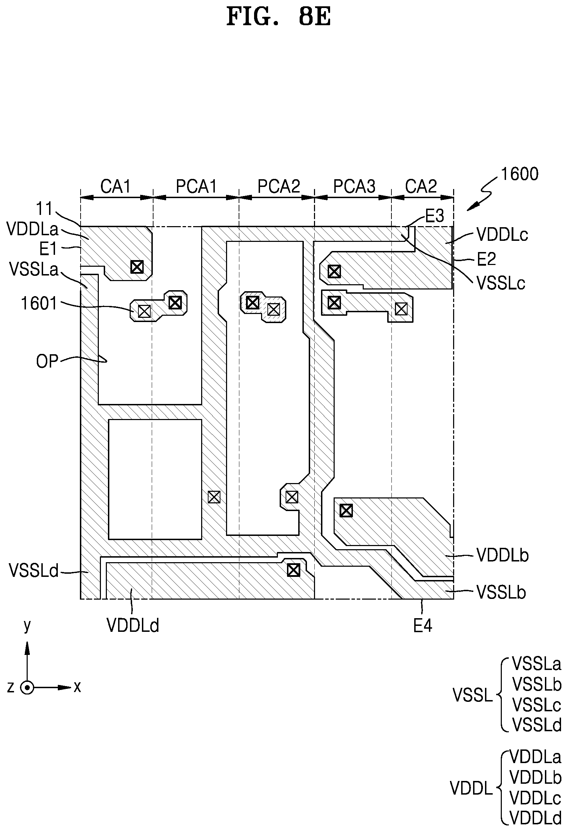

Referring to FIG. 8E, the fifth conductive layer 1600 may include twenty-seventh conductive patterns 1601, and a common voltage line VSSL and a driving voltage line VDDL each extending from the main island portion 11 to the main bridge portions. The fifth conductive layer 1600 may be disposed on the fourth conductive layer 1500, and one or more organic insulating layers (e.g., the second organic insulating layer) may be between the fourth conductive layer 1500 and the fifth conductive layer 1600.

The fifth conductive layer 1600 may include a stretchable conductive material. The fifth conductive layer 1600 may include a conductive material including molybdenum (Mo), aluminum (Al), copper (Cu), titanium (Ti), and the like, and may include a single layer or layers including the conductive material described above. For example, the fifth conductive layer 1600 may include a multilayer of Ti/Al/Ti.

The twenty-seventh conductive patterns 1601 may be arranged in the first circuit area PCA1, the second circuit area PCA2, and the third circuit area PCA3. The twenty-seventh conductive pattern 1601 of the first pixel driving circuit may extend from the first circuit area PCA1 to the first connection area CA1, and the twenty-seventh conductive pattern 1601 of the third pixel driving circuit may extend from the third circuit area PCA3 to the second connection area CA2. The twenty-seventh conductive patterns 1601 may be connected to the twenty-sixth conductive pattern 1501 of the fourth conductive layer 1500 and the first electrode pad 241 of the sixth conductive layer 1700 through contact holes. The twenty-seventh conductive pattern 1601 may connect the first electrode pad 241 of the light-emitting element (see LED of FIG. 6C) to the sixth transistor T6, the seventh transistor T7, and the first electrode of the auxiliary capacitor (see Ca of FIG. 6C) through the sixteenth conductive pattern 1405 of the third conductive layer 1400 and the twenty-sixth conductive pattern 1501 of the fourth conductive layer 1500.

The driving voltage line VDDL configured to transmit the driving power supply voltage (see VDD of FIG. 6C) may include a first driving voltage line VDDLa extending from the main island portion 11 to the first bridge portion, a second driving voltage line VDDLb extending from the main island portion 11 to the second bridge portion, a third driving voltage line VDDLc extending from the main island portion 11 to the third bridge portion, and a fourth driving voltage line VDDLd extending from the main island portion 11 to the fourth bridge portion.

The first driving voltage line VDDLa may be connected to a third voltage connection line VCL3 of a first pixel circuit driver through a contact hole. The second driving voltage line VDDLb, the third driving voltage line VDDLc, and the fourth driving voltage line VDDLd may each be connected to the third voltage connection line VCL3 of the third pixel circuit driver through a contact hole. The third voltage connection line VCL3 may be connected to the first voltage connection line VCL1 and the second voltage connection line VCL2 of the third conductive layer 1400 through contact holes.

The first driving voltage line VDDLa and the second driving voltage line VDDLb connecting the main island portions 11 adjacent to each other in the first direction (e.g., the +x direction and/or the -x direction) and the third driving voltage line VDDLc and the fourth driving voltage line VDDLd connecting the main island portions 11 adjacent to each other in the second direction (e.g., the +y direction and/or the -y direction) may be connected to each other through the voltage connection lines VCL1, VCL2, and VCL3 in the main island portion 11. The voltage connection lines VCL1, VCL2, and VCL3 may be arranged in a layer that is different from a layer in which the first driving voltage line VDDLa, the second driving voltage line VDDLb, the third driving voltage line VDDLc, and the fourth driving voltage line VDDLd are arranged.

The common voltage line VSSL configured to transmit the common power supply voltage (see VSS of FIG. 6C) may include a first common voltage line VSSLa extending from the main island portion 11 to the first bridge portion, a second common voltage line VSSLb extending from the main island portion 11 to the second bridge portion, a third common voltage line VSSLc extending from the main island portion 11 to the third bridge portion, and a fourth common voltage line VSSLd extending from the main island portion 11 to the fourth bridge portion.

The first common voltage line VSSLa, the second common voltage line VSSLb, the third common voltage line VSSLc, and the fourth common voltage line VSSLd may extend within the main island portion 11 in the first direction (e.g., the +x direction and/or the -x direction) and the second direction (e.g., the +y direction and/or the -y direction) and may be connected to each other. The first common voltage line VSSLa, the second common voltage line VSSLb, the third common voltage line VSSLc, and the fourth common voltage line VSSLd may be integrally formed as a single body. Openings OP may be defined between the first common voltage line VSSLa, the second common voltage line VSSLb, the third common voltage line VSSLc, and the fourth common voltage line VSSLd.

The first common voltage line VSSLa and the second common voltage line VSSLb connecting the main island portions 11 adjacent to each other in the first direction (e.g., the +x direction and/or the -x direction) and the third common voltage line VSSLc and the fourth common voltage line VSSLd connecting the main island portions 11 adjacent to each other in the second direction (e.g., the +y direction and/or the -y direction) may be connected to each other in the main island portion 11. Accordingly, the common voltage line VSSL may have a mesh structure in the display area (see DA of FIG. 1) of the stretchable display device (see 1 of FIG. 1).

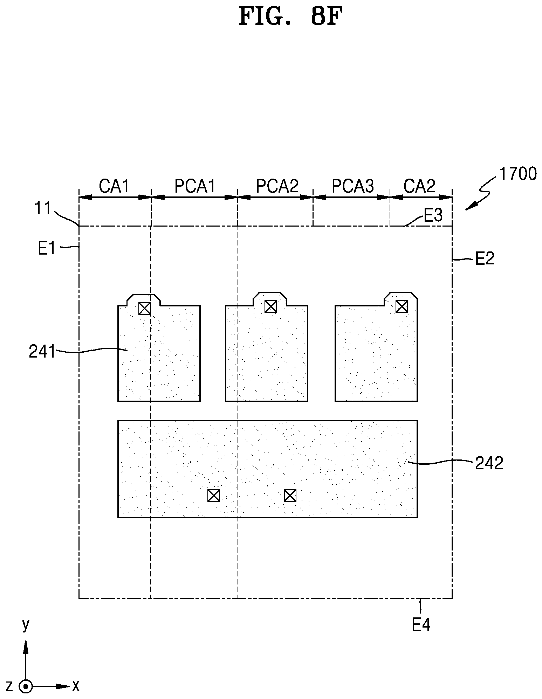

Referring to FIG. 8F, the sixth conductive layer 1700 may include first electrode pads 241 and second electrode pads 242. The sixth conductive layer 1700 may be disposed on the fifth conductive layer 1600, and one or more organic insulating layers (e.g., the third organic insulating layer) may be between the fifth conductive layer 1600 and the sixth conductive layer 1700. The sixth conductive layer 1700 may include a conductive material including molybdenum (Mo), aluminum (Al), copper (Cu), titanium (Ti), and the like, and may include a single layer or layers including the conductive material described above. In an embodiment, when the first electrode pads 241 and the second electrode pads 242 are connected to the electrodes of the light-emitting element (see LED of FIG. 6C) by eutectic bonding, the sixth conductive layer 1700 may have a multilayer structure including a copper (Cu) layer or may include a copper (Cu) alloy. In another embodiment, the sixth conductive layer 1700 may include a conductive organic material. For example, the sixth conductive layer 1700 may include carbon black. In another embodiment, the sixth conductive layer 1700 may include a conductive oxide, such as indium tin oxide (ITO), indium zinc oxide (IZO), zinc oxide (ZnO), indium oxide (In₂O₃), indium gallium oxide (IGO), or aluminum zinc oxide (AZO). Alternatively, the sixth conductive layer 1700 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or any compound thereof. In another embodiment, the sixth conductive layer 1700 may further include a layer including ITO, IZO, ZnO, AZO, or In₂O₃ above and/or below the reflective layer. For example, the sixth conductive layer 1700 may include an ITO layer, an Ag layer, and an ITO layer, which are stacked in this stated order.

The first electrode pads 241 may be connected to the first pixel driving circuit, the second pixel driving circuit, and the third pixel driving circuit, respectively. The first electrode pads 241 may each have an island shape. The first electrode pad 241 may be connected to the twenty-seventh conductive pattern 1601 of the fifth conductive layer 1600 through contact holes. The first electrode pad 241 may connect the first electrode of the light-emitting element (see LED of FIG. 6C) to the sixth transistor T6, the seventh transistor T7, and the first electrode of the auxiliary capacitor (see Ca of FIG. 6C).

The second electrode pad 242 may extend from the first connection area CA1 to the second connection area CA2 across the first circuit area PCA1, the second circuit area PCA2, and the third circuit area PCA3. The second electrode pad 242 may have an island shape in which the length in the first direction (e.g., the +x direction and/or the -x direction) is greater than the length in the second direction (e.g., the +y direction and/or the -y direction). The second electrode pad 242 may be commonly provided in the light-emitting elements arranged in the main island portion 11. For example, the second electrodes of each of the first light-emitting element, the second light-emitting element, and the third light-emitting element may be connected to the second electrode pad 242. The second electrode pad 242 may be connected to the common voltage line VSSL of the fifth conductive layer 1600 through contact holes.

In the embodiment illustrated in FIG. 8F, the light-emitting element may include an inorganic light-emitting diode (see 230 of FIG. 7B), but in other embodiments, the light-emitting element may include an organic light-emitting diode (see 220 of FIG. 7A). For example, the sixth conductive layer 1700 may include a first electrode (see 221 of FIG. 7A) instead of the first electrode pad 241. In this case, the sixth conductive layer 1700 may include a conductive oxide, such as ITO, IZO, ZnO, In₂O₃, IGO, or AZO. Alternatively, the sixth conductive layer 1700 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or any compound thereof. In another embodiment, the sixth conductive layer 1700 may further include a layer including ITO, IZO, ZnO, AZO, or In₂O₃ above and/or below the reflective layer.

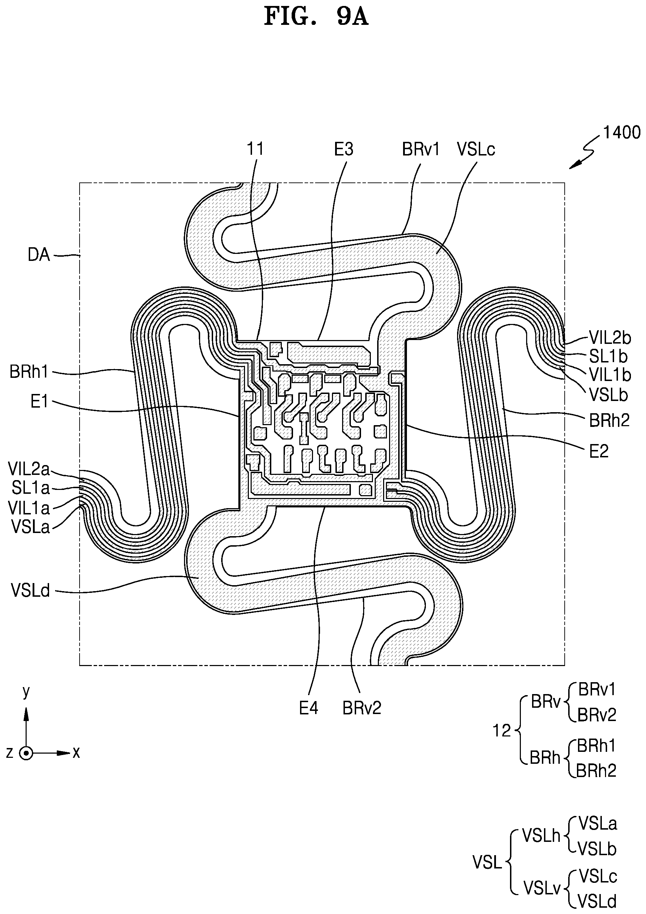

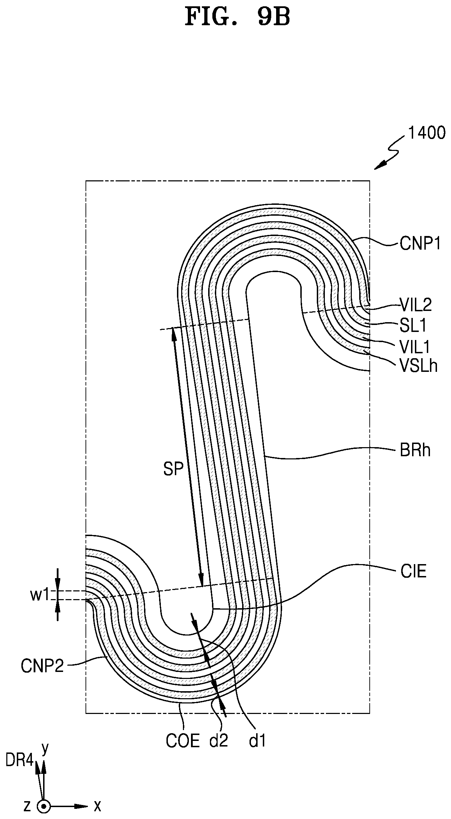

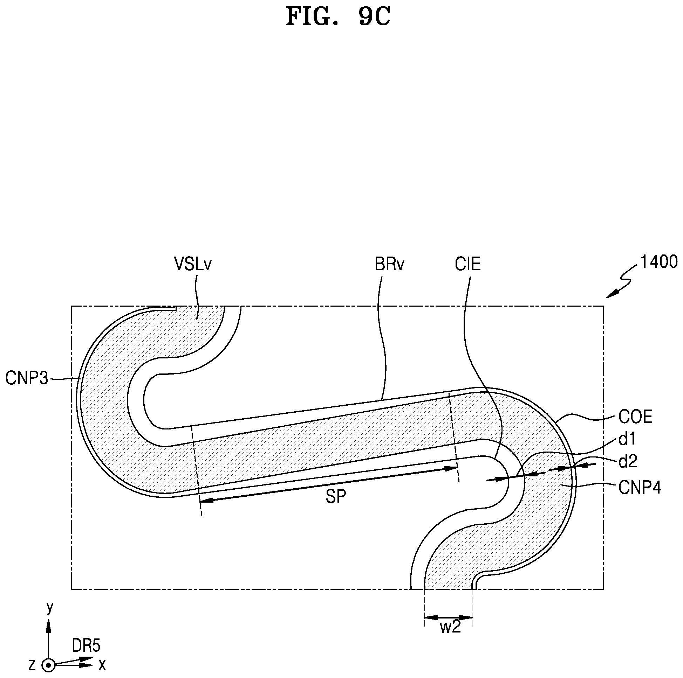

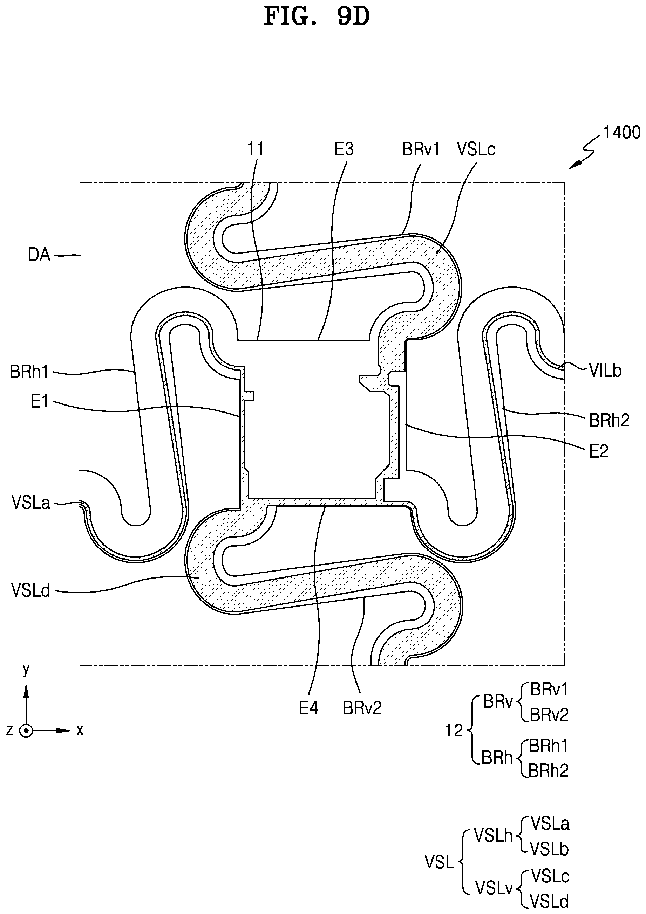

FIG. 9A is a layout diagram schematically illustrating a third conductive layer of a stretchable display device, according to an embodiment, FIGS. 9B and 9C are layout diagrams schematically illustrating a portion of the third conductive layer of the stretchable display device, according to an embodiment, and FIG. 9D is a layout diagram schematically illustrating a sustain voltage line of the stretchable display device, according to an embodiment.

Referring to FIGS. 9A to 9D, the stretchable display device may include a main island portion 11 and a plurality of main bridge portions 12 connected to the main island portion 11 in a display area DA. The main bridge portion 12 may include horizontal bridge portions BRh on opposite sides of the main island portion 11 in the first direction (e.g., the +x direction and/or the -x direction), respectively, and vertical bridge portions BRv on opposite sides of the main island portion 11 in the second direction (e.g., the +y direction and/or the -y direction), respectively.

The horizontal bridge portions BRh may include a first bridge portion BRh1 arranged at a first boundary E1 of the main island portion 11 and a second bridge portion BRh2 arranged at a second boundary E2 of the main island portion 11. The first bridge portion BRh1 may be arranged adjacent to a corner at which the first boundary E1 of the main island portion 11 meets a third boundary E3 of the main island portion 11. The second bridge portion BRh2 may be arranged adjacent to a corner at which the second boundary E2 of the main island portion 11 meets a fourth boundary E4 of the main island portion 11. The first bridge portion BRh1 and the second bridge portion BRh2 may connect the main island portions 11 adjacent to each other in the first direction (e.g., the +x direction and/or the -x direction).

Outside the first and second boundaries E1 and E2 of the main island portion 11, the first bridge portion BRh1 and the second bridge portion BRh2 may have the same shape. As illustrated in FIG. 9B, the horizontal bridge portion BRh may include a first curved portion CNP1, a second curved portion CNP2, and a straight portion SP connecting the first curved portion CNP1 to the second curved portion CNP2. The straight portion SP of the horizontal bridge portion BRh may extend in a fourth direction DR4 crossing the first direction (e.g., the +x direction and/or the -x direction) and the second direction (e.g., the +y direction and/or the -y direction) and parallel to the plane defined by the first direction (e.g., the +x direction and/or the -x direction) and the second direction (e.g., the +y direction and/or the -y direction).

The first bridge portion BRh1 may include a 1^{st}-1 initialization voltage line VIL1a, a 2^{nd}-1 initialization voltage line VIL2a, a 1^{st}-1 scan line SL1a, and a first sustain voltage line VSLa, which are arranged in the third conductive layer 1400. The second bridge portion BRh2 may include a 1^{st}-2 initialization voltage line VIL1b, a 2^{nd}-2 initialization voltage line VIL2b, a 1^{st}-2 scan line SL1b, and a second sustain voltage line VSLb, which are arranged in the third conductive layer 1400.

The 1^{st}-1 initialization voltage line VIL1a and the 1^{st}-2 initialization voltage line VIL1b may be connected to each other through an eleventh conductive pattern (see 1305 of FIG. 8B) of a second conductive layer (see 1300 of FIG. 8B) in the main island portion 11. The 1^{st}-1 initialization voltage line VIL1a and the 1^{st}-2 initialization voltage line VIL1b may be a first initialization voltage line VIL1 configured to transmit the first initialization voltage (see Vint of FIG. 6C) to one terminal of a fourth transistor (see T4 of FIG. 8A).

The 2^{nd}-1 initialization voltage line VIL2a and the 2^{nd}-2 initialization voltage line VIL2b may be connected to each other through a tenth conductive pattern (see 1304 of FIG. 8B) of a second conductive layer (see 1300 of FIG. 8B) in the main island portion 11. The 2^{nd}-1 initialization voltage line VIL2a and the 2^{nd}-2 initialization voltage line VIL2b may be a second initialization voltage line VIL2 configured to transmit the second initialization voltage (see Vaint of FIG. 6C) to one terminal of a seventh transistor (see T7 of FIG. 8A).

The 1^{st}-1 scan line SL1a and the 1^{st}-2 scan line SL1b may be connected to each other through a fifth conductive pattern (see 1205 of FIG. 8A) of a first conductive layer (see 1200 of FIG. 8A) in the main island portion 11. The 1^{st}-1 scan line SL1a and the 1^{st}-2 scan line SL1b may be a first scan line SL1 configured to transmit the first scan signal (see GW of FIG. 6C) to a gate of a second transistor (see T2 of FIG. 8A) and a gate of a third transistor (see T3 of FIG. 8A).

The horizontal bridge portion BRh may include a first initialization voltage line VIL1, a second initialization voltage line VIL2, and a first scan line SL1, which connect the main island portions 11 adjacent to each other in the first direction (e.g., the +x direction and/or the -x direction) in the third conductive layer 1400.

The first sustain voltage line VSLa and the second sustain voltage line VSLb may be a horizontal sustain voltage line (or "first voltage line") VSLh. The horizontal bridge portion BRh may include the horizontal sustain voltage line VSLh connecting the main island portions 11 adjacent to each other in the first direction (e.g., the +x direction and/or the -x direction). The horizontal sustain voltage line VSLh may have a first width w1 in a direction perpendicular to an extension direction of the horizontal sustain voltage line VSLh.

As illustrated in FIG. 9B, the horizontal sustain voltage line VSLh, the first initialization voltage line VIL1, the first scan line SL1, and the second initialization voltage line VIL2 may be sequentially apart from each other in a direction from a curved inner boundary CIE to a curved outer boundary COE in the first curved portion CNP1 of the horizontal bridge portion BRh, and the second initialization voltage line VIL2, the first scan line SL1, the first initialization voltage line VIL1, and the horizontal sustain voltage line VSLh may be sequentially apart from each other in a direction from the curved inner boundary CIE to the curved outer boundary COE in the second curved portion CNP2.

The wiring closest to the curved inner boundary CIE may be apart from the curved inner boundary CIE by a first distance d1, and the wiring closest to the curved outer boundary COE may be apart from the curved outer boundary COE by a second distance d2. For example, as illustrated in FIG. 9B, in the second curved portion CNP2, the second initialization voltage line VIL2, which is the wiring closest to the curved outer boundary COE, may be apart from the curved inner boundary CIE by the first distance d1, and the horizontal sustain voltage line VSLh, which is the wiring closest to the curved inner boundary CIE, may be apart from the curved outer boundary COE by the second distance d2. When the stretchable display device (see 1 of FIG. 1) is stretched by an external force, greater stress may be applied to the curved inner boundary CIE than to the curved outer boundary COE. Accordingly, the first distance d1 may be greater than the second distance d2.

The vertical bridge portions BRv may include a third bridge portion BRv1 arranged at the third boundary E3 of the main island portion 11 and a fourth bridge portion BRv2 arranged at the fourth boundary E4 of the main island portion 11. The third bridge portion BRv1 may be arranged adjacent to a corner at which the third boundary E3 of the main island portion 11 meets the second boundary E2 of the main island portion 11. The fourth bridge portion BRv2 may be arranged adjacent to a corner at which the first boundary E1 of the main island portion 11 meets the fourth boundary E4 of the main island portion 11. The third bridge portion BRv1 and the fourth bridge portion BRv2 may connect the main island portions 11 adjacent to each other in the second direction (e.g., the +y direction and/or the -y direction).

Outside the third and fourth boundaries E3 and E4 of the main island portion 11, the third bridge portion BRv1 and the fourth bridge portion BRv2 may have the same shape. As illustrated in FIG. 9C, the vertical bridge portion BRv may include a third curved portion CNP3, a fourth curved portion CNP4, and a straight portion SP connecting the third curved portion CNP3 to the fourth curved portion CNP4. The straight portion SP of the vertical bridge portion BRv may extend in a fifth direction DR5 crossing the first direction (e.g., the +x direction and/or the -x direction) and the second direction (e.g., the +y direction and/or the -y direction).

The third bridge portion BRv1 may include a third sustain voltage line VSLc arranged in the third conductive layer 1400, and the fourth bridge portion BRv2 may include a fourth sustain voltage line VSLd arranged in the third conductive layer 1400. The third sustain voltage line VSLc and the fourth sustain voltage line VSLd may be a vertical sustain voltage line (or "fourth voltage line") VSLv. The vertical sustain voltage line VSLv may have a second width w2 in a direction perpendicular to an extension direction of the vertical sustain voltage line VSLv. The second width w2 of the vertical sustain voltage line VSLv may be greater than the first width w1 of the horizontal sustain voltage line VSLh.

In an embodiment, the vertical bridge portion BRv may include only the vertical sustain voltage line VSLv in the third conductive layer 1400. Accordingly, the second width w2 of the vertical sustain voltage line VSLv may have the greatest width among the wirings WL included in the main bridge portions (see 12 of FIG. 5).

In an embodiment, a ratio of the first width w1 of the horizontal sustain voltage line VSLh to the second width w2 of the vertical sustain voltage line VSLv may change according to the length of the display area (see DA of FIG. 1) in the first direction (e.g., the +x direction and/or the -x direction) and the length of the display area (see DA of FIG. 1) in the second direction (e.g., the +y direction and/or the -y direction). For example, when the display area DA has a long shape in the second direction (e.g., the +y direction and/or the -y direction), stress applied to the vertical sustain voltage line VSLv may be greater than stress applied to the horizontal sustain voltage line VSLh. Accordingly, the second width w2 of the vertical sustain voltage line VSLv may be greater than the first width w1 of the horizontal sustain voltage line VSLh.

As illustrated in FIG. 9C, the vertical bridge portion BRv may be apart from the curved inner boundary CIE by a first distance d1 and may be apart from the curved outer boundary COE by a second distance d2. The first distance d1 may be greater than the second distance d2.

As illustrated in FIG. 9D, the first sustain voltage line VSLa, the second sustain voltage line VSLb, the third sustain voltage line VSLc, and the fourth sustain voltage line VSLd may extend along the first boundary E1, the second boundary E2, and the fourth boundary E4 of the main island portion 11 and may be connected to each other. The first sustain voltage line VSLa, the second sustain voltage line VSLb, the third sustain voltage line VSLc, and the fourth sustain voltage line VSLd may be integrally formed as a single body in the third conductive layer 1400 and may have a mesh structure that connects the main island portions 11 adjacent to each other in the first direction (e.g., the +x direction and/or the -x direction) to the main island portions 11 adjacent to each other in the second direction (e.g., the +y direction and/or the -y direction)1).

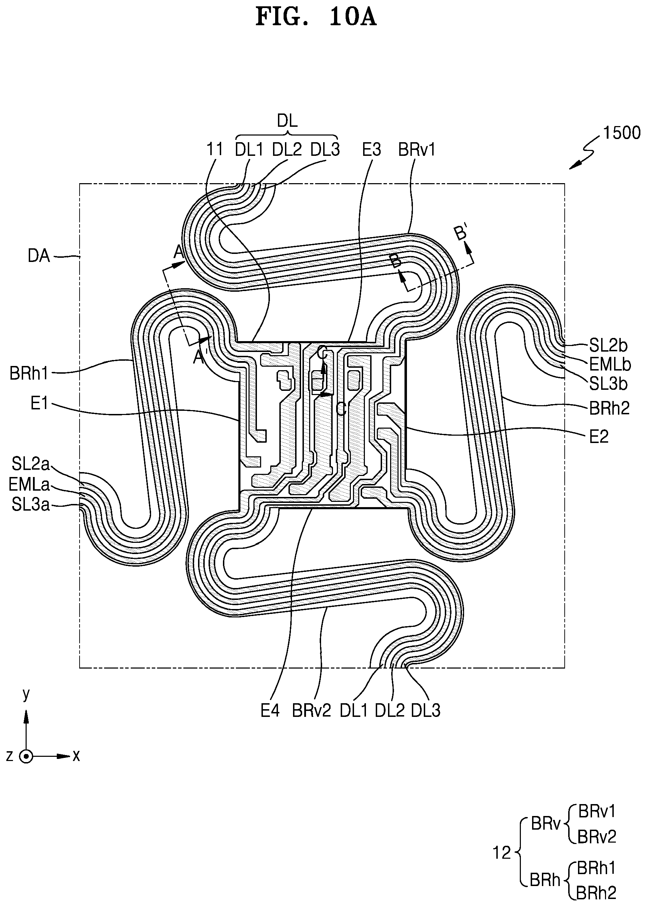

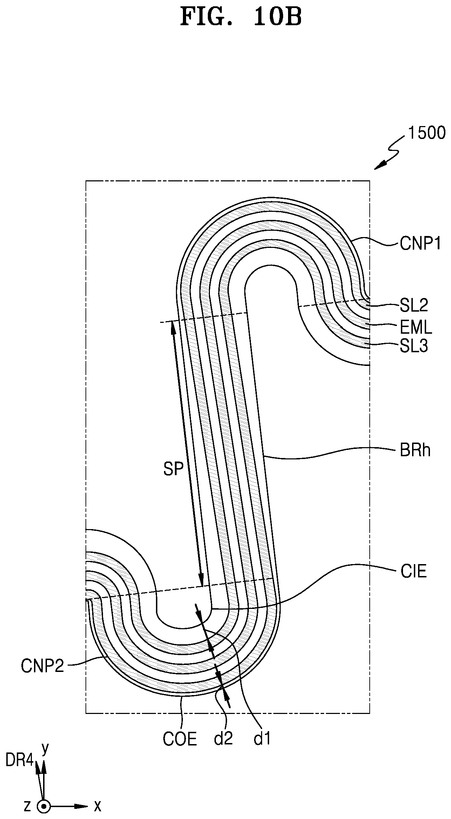

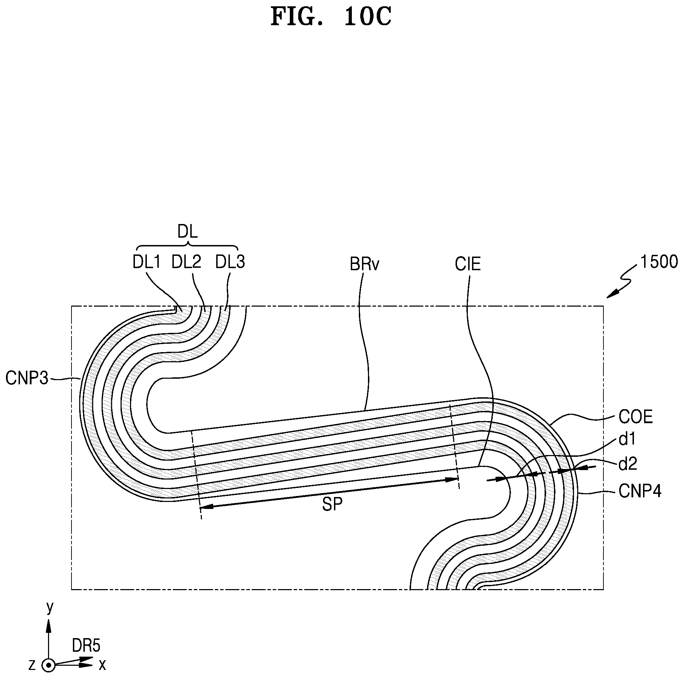

FIG. 10A is a layout diagram schematically illustrating the fourth conductive layer 1500 of the stretchable display device, according to an embodiment, and FIGS. 10B and 10C are layout diagrams schematically illustrating a portion of the fourth conductive layer 1500 of the stretchable display device, according to an embodiment.

Referring to FIGS. 10A to 10C, the stretchable display device may include a main island portion 11 and a plurality of main bridge portions 12 connected to the main island portion 11 in a display area DA.

The main bridge portion 12 may include horizontal bridge portions BRh and vertical bridge portions BRv. A first bridge portion BRh1 arranged at a first boundary E1 of the main island portion 11 and a second bridge portion BRh2 arranged at a second boundary E2 may be horizontal bridge portions BRh having the same shape outside the first and second boundaries E1 and E2 of the main island portion 11.

The first bridge portion BRh1 may include a 2^{nd}-1 scan line SL2a, a first emission control line EMLa, and a 3^{rd}-1 scan line SL3a, which are arranged in the fourth conductive layer 1500. The second bridge portion BRh2 may include a 2^{nd}-2 scan line SL2b, a second emission control line EMLb, and a 3^{rd}-2 scan line SL3b, which are arranged in the fourth conductive layer 1500.

The 2^{nd}-1 scan line SL2a and the 2^{nd}-2 scan line SL2b may be connected to each other through the fifteenth conductive pattern 1404 of the third conductive layer 1400, the twenty-third conductive pattern 1412, and the third conductive pattern 1203 of the first conductive layer 1200 in the main island portion 11. The 2^{nd}-1 scan line SL2a and the 2^{nd}-2 scan line SL2b may be a second scan line SL2 configured to transmit the second scan signal (see GB of FIG. 6C) to the gate of the seventh transistor (see T7 of FIG. 8A) and the gate of the ninth transistor (see T9 of FIG. 8A).

The first emission control line EMLa and the second emission control line EMLb may be connected to each other through the thirteenth conductive pattern 1402 of the third conductive layer 1400, the fourth conductive pattern 1204 of the first conductive layer 1200, and the twenty-fourth conductive pattern 1413 of the third conductive layer 1400 in the main island portion 11. The first emission control line EMLa and the second emission control line EMLb may be an emission control line EML configured to transmit the emission control signal (see EM of FIG. 6C) to the gate of the fifth transistor (see T5 of FIG. 8A), the gate of the sixth transistor (see T6 of FIG. 8A), and the gate of the eighth transistor (see T8 of FIG. 8A).

The 3^{rd}-1 scan line SL3a and the 3^{rd}-2 scan line SL3b may be connected to each other through the fourteenth conductive pattern 1403 of the third conductive layer 1400, the sixth conductive pattern 1206 of the first conductive layer 1200, and the twenty-fifth conductive pattern 1414 of the third conductive layer 1400 in the main island portion 11. The 3^{rd}-1 scan line SL3a and the 3^{rd}-2 scan line SL3b may be a third scan line SL3 configured to transmit the third scan signal (see GI of FIG. 6C) to the gate of the fourth transistor (see T4 of FIG. 8A).

That is, as illustrated in FIG. 10B, the horizontal bridge portion BRh may include a second scan line SL2, an emission control line EML, and a third scan line SL3, which connect the main island portions 11 adjacent to each other in the first direction (e.g., the +x direction and/or the -x direction) in the fourth conductive layer 1500.

The third scan line SL3, the emission control line EML, and the second scan line SL2 may be sequentially apart from each other in the first curved portion CNP1 in a direction from the curved inner boundary CIE to the curved outer boundary COE, and the second scan line SL2, the emission control line EML, and the third scan line SL3 may be sequentially apart from each other in the second curved portion CNP2 in a direction from the curved inner boundary CIE to the curved outer boundary COE.

The wiring closest to the curved inner boundary CIE may be apart from the curved inner boundary CIE by a first distance d1, and the wiring closest to the curved outer boundary COE may be apart from the curved outer boundary COE by a second distance d2. For example, as illustrated in FIG. 10B, in the second curved portion CNP2, the second scan line SL2 may be apart from the curved inner boundary CIE by the first distance d1, and the third scan line SL3 may be apart from the curved outer boundary COE by the second distance d2. The first distance d1 may be greater than the second distance d2.

A third bridge portion BRv1 arranged at a third boundary E3 of the main island portion 11 and a fourth bridge portion BRv2 arranged at a fourth boundary E4 may be vertical bridge portions BRv having the same shape outside the third and fourth boundaries E3 and E4 of the main island portion 11.

The third bridge portion BRv1 and the fourth bridge portion BRv2 may include a first data line DL1, a second data line DL2, and a third data line DL3, which are arranged in the fourth conductive layer 1500. The first data line DL1, the second data line DL2, and the third data line DL3 may cross the main island portion 11, and the first data line DL1, the second data line DL2, and the third data line DL3 may be integrally formed as a single body. That is, the vertical bridge portion BRv may include a data line DL connecting the main island portions 11 adjacent to each other in the second direction (e.g., the +y direction and/or the -y direction) in the fourth conductive layer 1500.

Each of the first data line DL1, the second data line DL2, and the third data line DL3 may be connected to the first semiconductor pattern 1101, the second semiconductor pattern 1102, or the third semiconductor pattern 1103 of the semiconductor layer 1100 through the twenty-second conductive patterns (see 1411 of 8C) of the third conductive layer (see 1400 of FIG. 8C), and may be configured to transmit the data signal (see Dm of FIG. 6C) to one terminal of the second transistor (see T2 of FIG. 8A) of the corresponding pixel driving circuit.

As illustrated in FIG. 10C, the third data line DL3, the second data line DL2, and the first data line DL1 may be sequentially apart from each other in the third curved portion CNP3 in a direction from the curved inner boundary CIE to the curved outer boundary COE, and the first data line DL1, the second data line DL2, and the third data line DL3 may be sequentially apart from each other in the fourth curved portion CNP4 in a direction from the curved inner boundary CIE to the curved outer boundary COE.

The wiring closest to the curved inner boundary CIE may be apart from the curved inner boundary CIE by a first distance d1, and the wiring closest to the curved outer boundary COE may be apart from the curved outer boundary COE by a second distance d2. For example. in the fourth curved portion CNP4, the first data line DL1 may be apart from the curved inner boundary CIE by the first distance d1, and the third data line DL3 may be apart from the curved outer boundary COE by the second distance d2. The first distance d1 may be greater than the second distance d2.

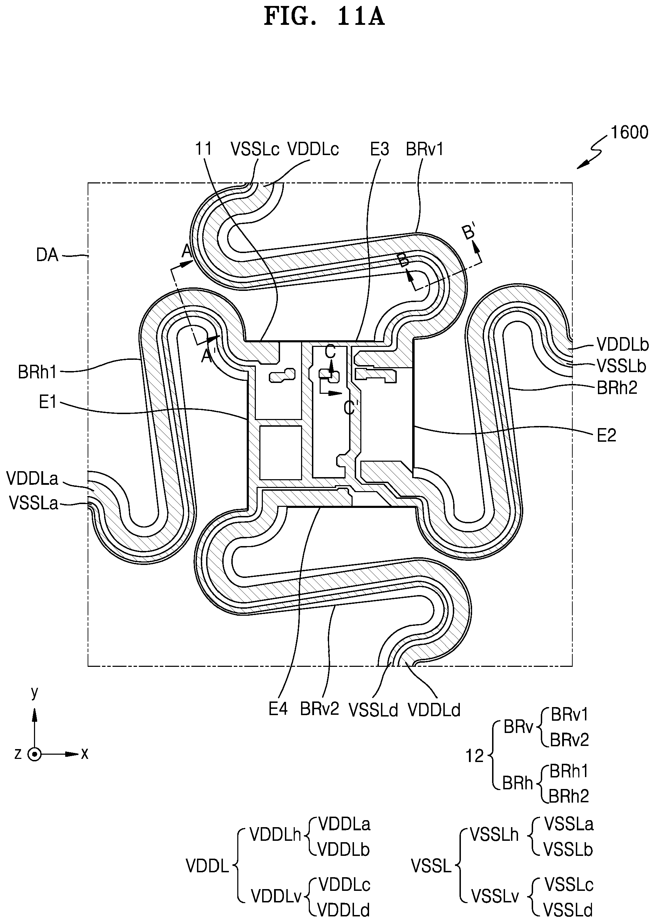

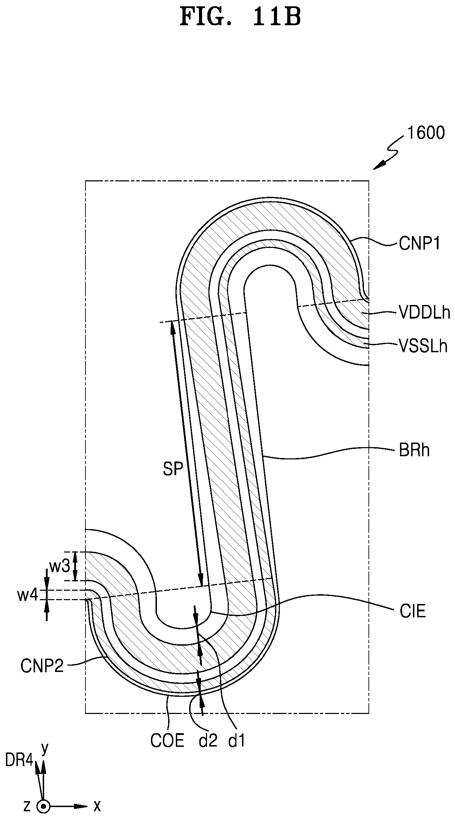

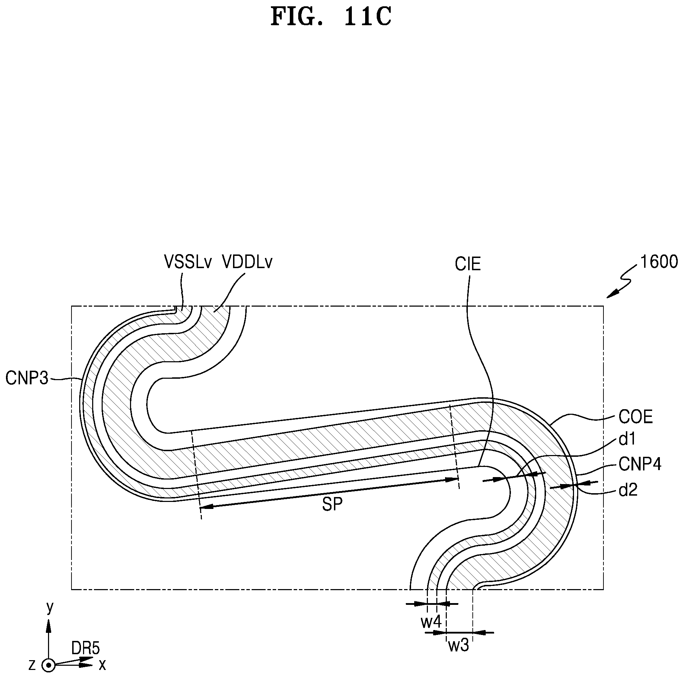

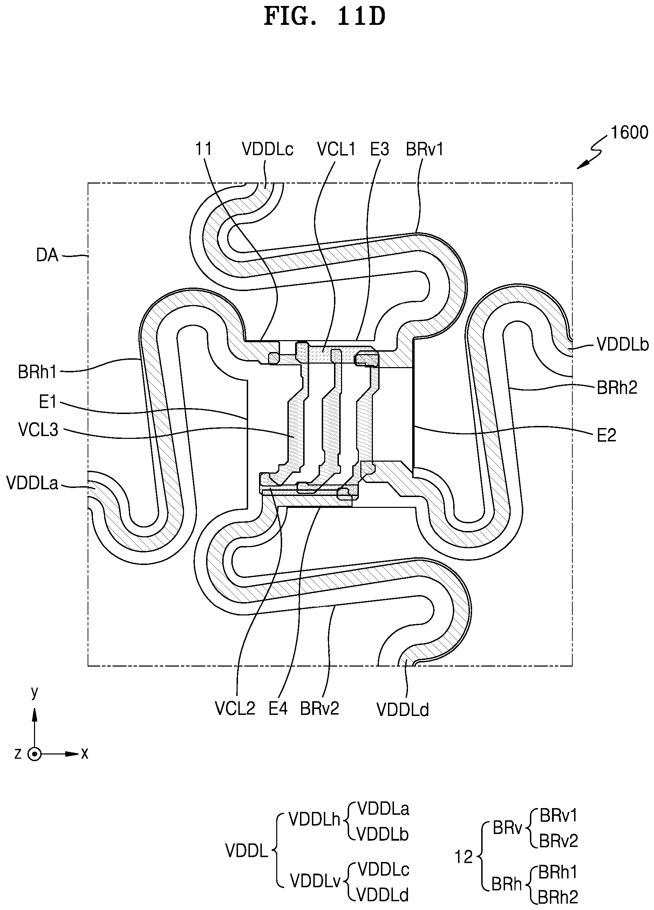

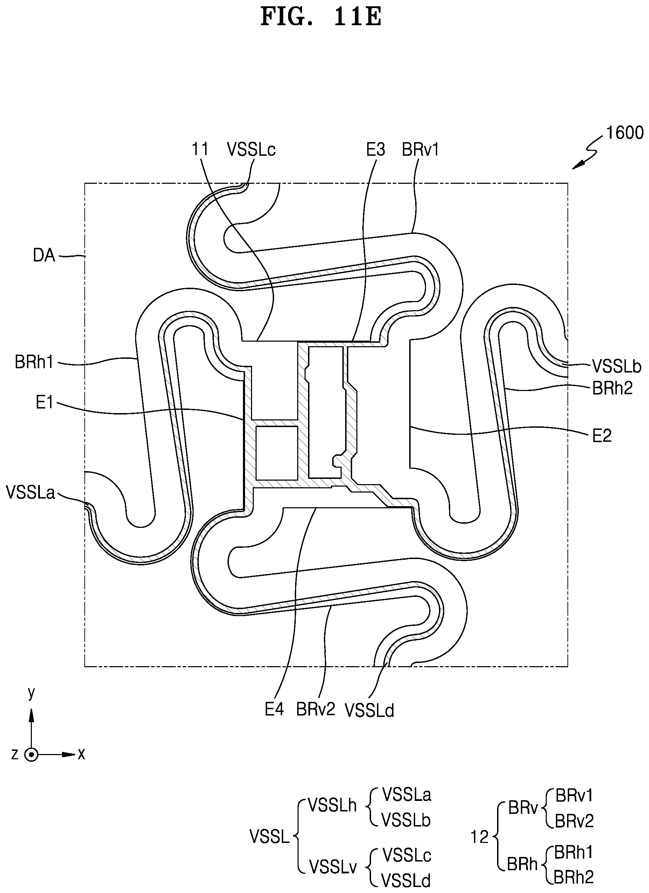

FIG. 11A is a layout diagram schematically illustrating the fifth conductive layer of the stretchable display device, according to an embodiment, FIGS. 11B and 11C are layout diagrams schematically illustrating a portion of the fifth conductive layer of the stretchable display device, according to an embodiment, FIG. 11D is a layout diagram schematically illustrating the driving voltage line of the stretchable display device, according to an embodiment, and FIG. 11E is a layout diagram schematically illustrating the common voltage line of the stretchable display device, according to an embodiment.

Referring to FIGS. 11A to 11E, the stretchable display device may include a main island portion 11 and a plurality of main bridge portions 12 connected to the main island portion 11 in a display area DA.

The main bridge portion 12 may include a first bridge portion BRh1 arranged at the first boundary E1 of the main island portion 11, a second bridge portion BRh2 arranged at the second boundary E2, a third bridge portion BRv1 arranged at the third boundary E3 of the main island portion 11, and a fourth bridge portion BRv2 arranged at the fourth boundary E4. Outside the boundary of the main island portion 11, the first bridge portion BRh1 and the second bridge portion BRh2 may have the same shape and the third bridge portion BRv1 and the fourth bridge portion BRv2 may have the same shape.

The first bridge portion BRh1 and the second bridge portion BRh2 may be a horizontal bridge portion BRh connecting the main island portions 11 adjacent to each other in the first direction (e.g., the +x direction and/or the -x direction), and the third bridge portion BRv1 and the fourth bridge portion BRv2 may be a vertical bridge portion BRv connecting the main island portions 11 adjacent to each other in the second direction (e.g., the +y direction and/or the -y direction).

The first bridge portion BRh1 may include a first driving voltage line VDDLa and a first common voltage line VSSLa, which are arranged in the fifth conductive layer 1600, and the second bridge portion BRh2 may include a second driving voltage line VDDLb and a second common voltage line VSSLb, which are arranged in the fifth conductive layer 1600. The third bridge portion BRv1 may include a third driving voltage line VDDLc and a third common voltage line VSSLc, which are arranged in the fifth conductive layer 1600, and the fourth bridge portion BRv2 may include a fourth driving voltage line VDDLd and a fourth common voltage line VSSLd, which are arranged in the fifth conductive layer 1600.

The first driving voltage line VDDLa and the second driving voltage line VDDLb may be a horizontal driving voltage line (or "second voltage line") VDDLh connecting the main island portions 11 adjacent to each other in the first direction (e.g., the +x direction and/or the -x direction). The third driving voltage line VDDLc and the fourth driving voltage line VDDLd may be a vertical driving voltage line (or "fifth voltage line") VDDLv connecting the main island portions 11 adjacent to each other in the second direction (e.g., the +y direction and/or the -y direction).

The first common voltage line VSSLa and the second common voltage line VSSLb may be a horizontal common voltage line (or "third voltage line") VSSLh connecting the main island portions 11 adjacent to each other in the first direction (e.g., the +x direction and/or the -x direction). The third common voltage line VSSLc and the fourth common voltage line VSSLd may be a vertical common voltage line (or "sixth voltage line") VSSLv connecting the main island portions 11 adjacent to each other in the second direction (e.g., the +y direction and/or the -y direction).

That is, as illustrated in FIGS. 11B and 11C, the horizontal bridge portion BRh may include the horizontal driving voltage line VDDLh and the horizontal common voltage line VSSLh, and the vertical bridge portion BRv may include the vertical driving voltage line VDDLv and the vertical common voltage line VSSLv.

The horizontal common voltage line VSSLh and the horizontal driving voltage line VDDLh may be apart from each other in the first curved portion CNP1 in a direction from the curved inner boundary CIE to the curved outer boundary COE, and the horizontal driving voltage line VDDLh and the horizontal common voltage line VSSLh may be apart from each other in the second curved portion CNP2 in a direction from the curved inner boundary CIE to the curved outer boundary COE.

The vertical driving voltage line VDDLv and the vertical common voltage line VSSLv may be apart from each other in the third curved portion CNP3 in a direction from the curved inner boundary CIE to the curved outer boundary COE, and the vertical common voltage line VSSLv and the vertical driving voltage line VDDLv may be apart from each other in the fourth curved portion CNP4 in a direction from the curved inner boundary CIE to the curved outer boundary COE.

The wiring closest to the curved inner boundary CIE may be apart from the curved inner boundary CIE by a first distance d1, and the wiring closest to the curved outer boundary COE may be apart from the curved outer boundary COE by a second distance d2. For example, as illustrated in FIG. 11B, in the second curved portion CNP2, the horizontal driving voltage line VDDLh may be apart from the curved inner boundary CIE by the first distance d1, and the horizontal common voltage line VSSLh may be apart from the curved outer boundary COE by the second distance d2. The first distance d1 may be greater than the second distance d2. Similarly, as illustrated in FIG. 11C, in the fourth curved portion CNP4, the vertical common voltage line VSSLv may be apart from the curved inner boundary CIE by the first distance d1, and the vertical driving voltage line VDDLv may be apart from the curved outer boundary COE by the second distance d2 that is less than the first distance d1.

The horizontal driving voltage line VDDLh and the vertical driving voltage line VDDLv may each have a third width w3 in a direction perpendicular to an extension direction of the corresponding voltage line of the horizontal driving voltage line VDDLh and the vertical driving voltage line VDDLv. The horizontal common voltage line VSSLh and the vertical common voltage line VSSLv may each have a fourth width w4 in a direction perpendicular to an extension direction of the corresponding voltage line of the horizontal common voltage line VSSLh and the vertical common voltage line VSSLv. When a change in luminance uniformity due to the voltage drop in the driving voltage line VDDL is greater than a change in luminance uniformity due to the voltage drop in the common voltage line VSSL, the third width w3 may be greater than the fourth width w4. For example, the third width w3 may be about 1.2 times to about 2 times the fourth width w4. In an embodiment, the third width w3 may be about 1.5 times the fourth width w4.

In another embodiment, when a change in luminance uniformity due to the voltage drop in the common voltage line VSSL is greater than a change in luminance uniformity due to the voltage drop in the driving voltage line VDDL, the third width w3 may be less than or equal to the fourth width w4.

The sustain voltage line (see VSL of FIG. 9A) may compensate for the voltage drop in the driving voltage line VDDL by transmitting the sustain voltage (see VSUS of FIG. 6C) to the second node (see N2 of FIG. 6C) in the initialization period and the data write period. Therefore, in order to maximize the width, the sustain voltage line (see VSL of FIG. 9A) may be arranged in a layer (e.g., the third conductive layer 1400) that is different from a layer in which the common voltage line VSSL and the driving voltage line VDDL are arranged, and may be configured as a single wiring in the vertical bridge portion BRv. The second width (see w2 of FIG. 9C) may be greater than the third width w3 and the fourth width w4. In an embodiment, the second width (see w2 of FIG. 9C) may be about 1.2 times to about 2 times the fourth width w4.

As illustrated in FIG. 11D, the main island portion 11 may include a first voltage connection line VCL1, a second voltage connection line VCL2, and a third voltage connection line VCL3. The first voltage connection line VCL1, the second voltage connection line VCL2, and the third voltage connection line VCL3 may be arranged in a layer that is different from a layer in which the first driving voltage line VDDLa, the second driving voltage line VDDLb, the third driving voltage line VDDLc, and the fourth driving voltage line VDDLd are arranged. For example, the first driving voltage line VDDLa, the second driving voltage line VDDLb, the third driving voltage line VDDLc, and the fourth driving voltage line VDDLd may be electrically connected to each other through the first voltage connection line VCL1 and the second voltage connection line VCL2 arranged in the third conductive layer (see 1400 of FIG. 8C) and the third voltage connection line VCL3 arranged in the fourth conductive layer (see 1500 of FIG. 8D) within the main island portion 11.

The third voltage connection lines VCL3 may be electrically connected to the first semiconductor pattern 1101, the second semiconductor pattern 1102, or the third semiconductor pattern 1103 of the semiconductor layer (see 1100 of FIG. 8A) through the eighteenth conductive patterns 1407 of the third conductive layer (see 1400 of FIG. 8C), and may be configured to transmit the driving power supply voltage (see VDD of FIG. 6C) to one terminal of the eighth transistor (see T8 of FIG. 8A) of the corresponding pixel driving circuit.

The driving voltage line VDDL may have a mesh structure that connects the main island portions 11 adjacent to each other in the first direction (e.g., the +x direction and/or the -x direction) to the main island portions 11 adjacent to each other in the second direction (e.g., the +y direction and/or the -y direction).

Because the driving voltage line VDDL transmits the driving power supply voltage (see VDD of FIG. 6C) to one terminal of the eighth transistor (see T8 of FIG. 8A) located in the semiconductor layer (see 1100 of FIG. 8A), the driving voltage line VDDL may form a mesh structure connected in the main island portion 11 by using layers between the fifth conductive layer 1600 and the semiconductor layer 1100. The first driving voltage line VDDLa, the second driving voltage line VDDLb, the third driving voltage line VDDLc, and the fourth driving voltage line VDDLd may be electrically connected to each other so as not to be in contact with the common voltage line VSSL through the first voltage connection line VCL1 and the second connection line VCL2 arranged in the third conductive layer (see 1400 of FIG. 8C) and the third voltage connection line VCL3 arranged in the fourth conductive layer (see 1500 of FIG. 8D).

As illustrated in FIG. 11E, the first common voltage line VSSLa, the second common voltage line VSSLb, the third common voltage line VSSLc, and the fourth common voltage line VSSLd may extend within the main island portion 11 in the first direction (e.g., the +x direction and/or the -x direction) and the second direction (e.g., the +y direction and/or the -y direction) and may be electrically connected to each other. The first common voltage line VSSLa, the second common voltage line VSSLb, the third common voltage line VSSLc, and the fourth common voltage line VSSLd may be electrically connected to each other in the fifth conductive layer 1600 and integrally formed as a single body.

The common voltage line VSSL may have a mesh structure that connects the main island portions 11 adjacent to each other in the first direction (e.g., the +x direction and/or the -x direction) to the main island portions 11 adjacent to each other in the second direction (e.g., the +y direction and/or the -y direction).

Because the common voltage line VSSL is electrically connected only to the second electrode pad (see 242 of FIG. 8F) of the sixth conductive layer (see 1700 of FIG. 8F), the first common voltage line VSSLa, the second common voltage line VSSLb, the third common voltage line VSSLc, and the fourth common voltage line VSSLd may be arranged in the fifth conductive layer 1600, which is a conductive layer closest to the sixth conductive layer (see 1700 of FIG. 8F), may extend within the main island portion 11, and may be electrically connected to each other.

Because the common voltage line VSSL has a mesh structure and is configured to transmit the common power supply voltage (see VSS of FIG. 6C) to each of the light-emitting elements through the second electrode pad (see 242 of FIG. 8F), it is unnecessary to arrange a common power supply voltage line so as to transmit the common power supply voltage to the non-display area (see NDA of FIG. 1). Therefore, the stretchable display device according to embodiments may reduce dead space in which images are not displayed.

In an embodiment, when one electrode of the light-emitting element is electrically connected to the driving voltage line VDDL, for example, when the light-emitting element has an inverted structure, the first driving voltage line VDDLa, the second driving voltage line VDDLb, the third driving voltage line VDDLc, and the fourth driving voltage line VDDLd may be electrically connected to each other in the fifth conductive layer 1600 and integrally formed as a single body. At this time, the first common voltage line VSSLa, the second common voltage line VSSLb, the third common voltage line VSSLc, and the fourth common voltage line VSSLd may be electrically connected to each other in the main island portion 11 through the voltage connection lines arranged in a layer that is different from a layer in which the first common voltage line VSSLa, the second common voltage line VSSLb, the third common voltage line VSSLc, and the fourth common voltage line VSSLd are arranged.

The stretchable display device according to the embodiments described above may be used in various electronic apparatuses capable of providing images. The electronic apparatus refers to an apparatus that uses electricity and provides a certain image.

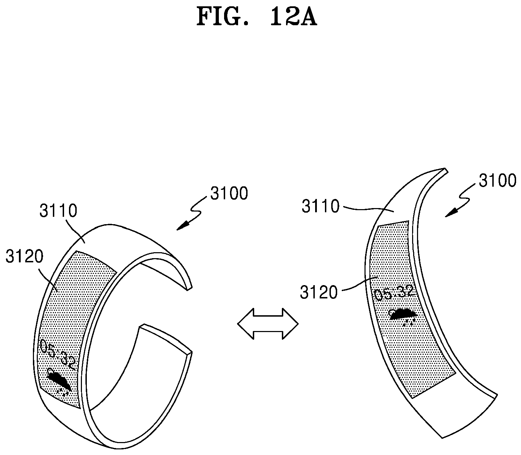

FIGS. 12A to 12G are perspective views schematically illustrating an electronic apparatus including the stretchable display device, according to embodiments.

Referring to FIG. 12A, the stretchable display device according to an embodiment may be used in a wearable electronic apparatus 3100 that is wearable on a part of a user's body. The wearable electronic apparatus 3100 may include a body 3110 and a display 3120 provided on the body 3110. The stretchable display device according to embodiments may be used as the display 3120 of the wearable electronic apparatus 3100. As illustrated in FIG. 12A, the wearable electronic apparatus 3100 may be variously modified. In an embodiment, the wearable electronic apparatus 3100 may be used as a smart watch or a smartphone according to a user's choice.

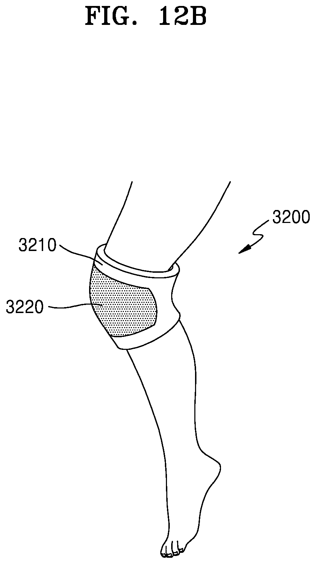

FIG. 12B illustrates a medical electronic apparatus 3200. In an embodiment, the medical electronic apparatus 3200 may include a body 3210 and a light emitter 3220. The stretchable display device according to embodiments may be used as the light emitter 3220 of the medical electronic apparatus 3200. The light emitter 3220 may emit light of a certain wavelength band (e.g., infrared light, visible light, etc.) to a patient's body. In an embodiment, the body 3210 may include a stretchable fiber material and may have a structure that is wearable on the body of the user who uses the light emitter.

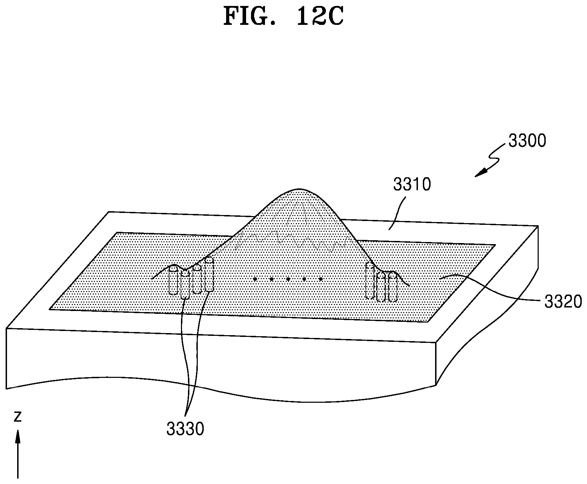

FIG. 12C illustrates an educational electronic apparatus 3300. In an embodiment, the educational electronic apparatus 3300 may include a display 3320 provided in a frame 3310. The display 3320 may use the stretchable display devices according to embodiments. The display 3320 may provide images such as a sea with waves, a mountain covered with snow, or a volcano with flowing lava. In this case, the display 3320 may extend in the height direction (e.g., the +z direction) to reflect the height of the waves, the mountain, or the volcano. In some embodiments, a portion of the display 3320 may show the movement of lava in three dimensions by sequentially changing the height in the direction in which the lava flows. The educational electronic apparatus 3300 may include a plurality of pins (or stroke portions, 3330) disposed on the back surface of the display 3320 so that the display 3320 extends in the height direction. As the pins 3330 move in the third direction (e.g., the +z direction or the -z direction), the image displayed on the display 3320 may be implemented to have a three-dimensional height. Although FIG. 12C illustrates the educational electronic apparatus 3300, the use of the educational electronic apparatus 3300 is not limited as long as the educational electronic apparatus 3300 provides certain image information.

The electronic apparatuses illustrated in FIGS. 12A to 12C are described as being variable in shape, but the disclosure is not limited thereto. As in the embodiments to be described below, the stretchable display device according to embodiments may be used in an electronic apparatus in which a part (e.g., a screen) capable of displaying an image is fixed.

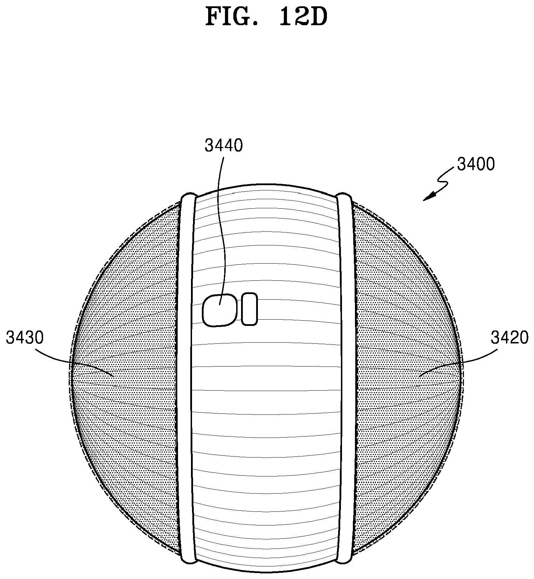

FIG. 12D illustrates a robot 3400 as an electronic apparatus according to an embodiment. The robot 3400 may recognize movement or objects by using a camera 3440 and may display certain images to a user on displays 3420 and 3430. In some embodiments, because the stretchable display devices according to the embodiment may be stretched in various directions, as described above, the stretchable display devices may be assembled into a body frame having a hemispherical shape. Accordingly, the robot 3400 may include the hemispherical displays 3420 and 3430.

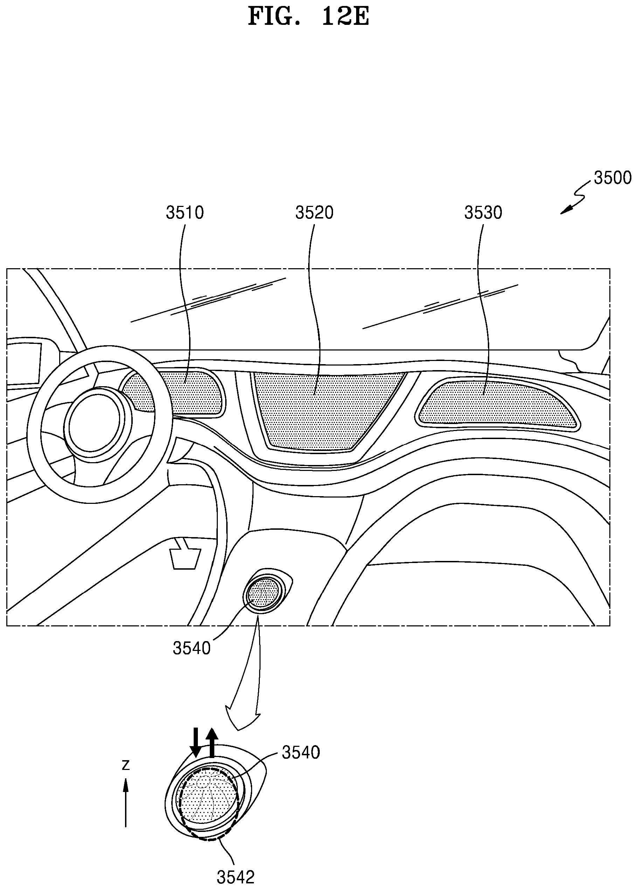

FIG. 12E illustrates a vehicle display device 3500 as an electronic apparatus according to an embodiment. The vehicle display device 3500 may include a cluster 3510, a center information display ("CID") 3520, and/or a co-driver display (or a passenger display). Because the stretchable display device according to an embodiment may be stretched in various directions, the stretchable display device may be used in the cluster 3510, the CID 3520, and/or the co-driver display, regardless of the shape of the internal frame of the vehicle.

Although FIG. 12E illustrates that the cluster 3510, the CID 3520, and/or the co-driver display are separated from each other, the disclosure is not limited thereto. In another embodiment, two or more selected from the cluster 3510, the CID 3520, and the co-driver display may be integrally connected to each other.

In some embodiments, the vehicle display device 3500 may include a button 3540 configured to display a certain image. Referring to the enlarged view of FIG. 12E, the hemispherical button 3540 may include an object 3542 configured to provide the feeling of using the button while moving in the +z direction or the -z direction, and a stretchable display device disposed on the object 3542. In some embodiments, when the object 3542 has a three-dimensionally round surface, the stretchable display device may also have a three-dimensionally round surface.

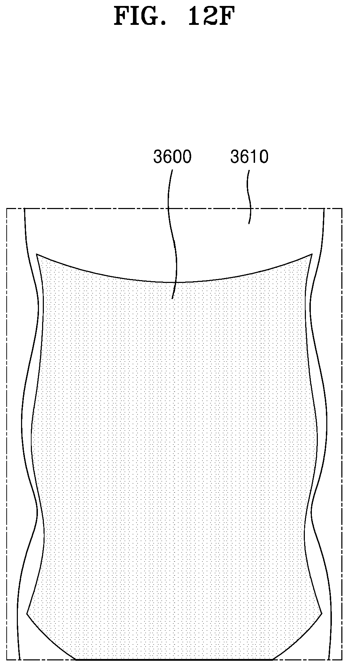

FIG. 12F illustrates that the electronic apparatus according to an embodiment is an advertising or exhibition electronic apparatus 3600. In some embodiments, the advertising or exhibition electronic apparatus 3600 may be installed on a fixed structure 3610, such as a wall or a pillar. When the structure 3610 includes an uneven surface as illustrated in FIG. 8F, the advertising or exhibition electronic apparatus 3600 may also be arranged along the uneven surface of the structure 3610. In some embodiments, the advertising or exhibition electronic apparatus 3600 may be installed on the structure 3610 by using a heat-shrinkable film or the like.

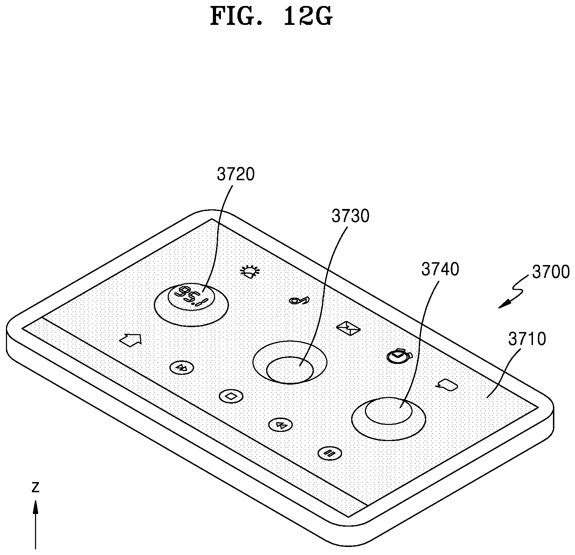

FIG. 12G illustrates that the electronic apparatus according to an embodiment is a controller 3700. The controller 3700 may include an image-type button. For example, the controller 3700 may include first to third button areas 3720, 3730, and 3740 in which a portion of a display 3710 protrudes in the +z direction or protrudes in the -z direction (or is recessed in the +z direction). In some embodiments, the first and third button areas 3720 and 3740 may protrude in the +z direction, and the second button area 3730 may protrude in the -z direction (or may be recessed in the +z direction).

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope as defined by the following claims.

## Claims

1. A display device comprising:
a plurality of island portions apart from each other;
a plurality of first bridge portions connecting island portions adjacent to each other in a first direction among the plurality of island portions, wherein the plurality of first bridge portions comprises a first voltage line, a second voltage line, and a third voltage line; and
a plurality of second bridge portions connecting island portions adjacent to each other in a second direction crossing the first direction among the plurality of island portions, wherein the plurality of second bridge portions comprises a fourth voltage line electrically connected to the first voltage line, a fifth voltage line electrically connected to the second voltage line, and a sixth voltage line electrically connected to the third voltage line,
wherein the first voltage line and the fourth voltage line are arranged in a first conductive layer, and
the second voltage line, the fifth voltage line, the third voltage line, and the sixth voltage line are arranged in a second conductive layer on the first conductive layer.

2. The display device of claim 1, wherein the first voltage line and the fourth voltage line extend to the plurality of island portions and are electrically connected to each other.

3. The display device of claim 1, wherein the first voltage line has a first width in a direction perpendicular to an extension direction of the first voltage line, and
the fourth voltage line has a second width greater than the first width in a direction perpendicular to an extension direction of the fourth voltage line.

4. The display device of claim 1, wherein the plurality of second bridge portions comprise only the fourth voltage line in the first conductive layer among the fourth, fifth, and sixth voltage lines.

5. The display device of claim 1, wherein the plurality of first bridge portions further comprise a first initialization voltage line and a second initialization voltage line, and
the first initialization voltage line and the second initialization voltage line are arranged in the first conductive layer.

6. The display device of claim 1, wherein each of the plurality of island portions comprises a plurality of voltage connection lines, and
the second voltage line and the fifth voltage line are electrically connected to each other through the plurality of voltage connection lines in the plurality of island portions.

7. The display device of claim 6, wherein the plurality of voltage connection lines are arranged in a layer that is different from a layer in which the second voltage line and the fifth voltage line are arranged.

8. The display device of claim 6, wherein the plurality of voltage connection lines comprise a first voltage connection line and a second voltage connection line each extending in the first direction, and a plurality of third voltage connection lines extending in the second direction,
the first voltage connection line and the second voltage connection line are arranged in the first conductive layer, and
the plurality of third voltage connection lines are arranged in a third conductive layer between the first conductive layer and the second conductive layer.

9. The display device of claim 8, wherein the second voltage line and the fifth voltage line are electrically connected to some of the plurality of third voltage connection lines, and
the plurality of third voltage connection lines are each electrically connected to the first voltage connection line and the second voltage connection line.

10. The display device of claim 1, wherein the third voltage line and the sixth voltage line extend to the plurality of island portions and are electrically connected to each other.

11. The display device of claim 1, wherein the second voltage line and the fifth voltage line each have a third width in a direction perpendicular to an extension direction of a corresponding voltage line of the second voltage line and the fifth voltage line, and
the third voltage line and the sixth voltage line each have a fourth width less than the third width in a direction perpendicular to an extension direction of a corresponding voltage line of the third voltage line and the sixth voltage line.

12. The display device of claim 11, wherein the fourth voltage line has a second width greater than the fourth width in a direction perpendicular to an extension direction of the fourth voltage line.

13. The display device of claim 1, wherein each of the plurality of island portions further comprises a light-emitting element, a first electrode pad electrically connected to a first electrode of the light-emitting element, and a second electrode pad electrically connected to a second electrode of the light-emitting element, and
the first electrode pad and the second electrode pad are arranged in a fourth conductive layer on the second conductive layer.

14. The display device of claim 1, wherein each of the plurality of island portions comprises a light-emitting element and a pixel driving circuit electrically connected to the light-emitting element, and
the pixel driving circuit comprises:
a driving transistor having a gate, a first terminal electrically connected to a first node, and a second terminal;
a data write transistor electrically connected to the first node and a data line;
a first compensation transistor electrically connected to the gate of the driving transistor and the second terminal of the driving transistor;
a first emission control transistor electrically connected to the first node and a second node;
a second emission control transistor electrically connected to the light-emitting element and the second terminal of the driving transistor;
a third emission control transistor electrically connected to the second node and a driving voltage line;
a second compensation transistor electrically connected to the second node and a sustain voltage line;
a storage capacitor electrically connected to the second node and the gate of the driving transistor; and
an auxiliary capacitor electrically connected to the sustain voltage line and a first electrode of the light-emitting element.

15. The display device of claim 14, wherein the sustain voltage line comprises the first voltage line and the fourth voltage line.

16. The display device of claim 14, wherein the auxiliary capacitor comprises
a first electrode and a second electrode overlapping the first electrode in a plan view, and
the first voltage line and the fourth voltage line are electrically connected to the second electrode.

17. The display device of claim 14, wherein a second electrode of the auxiliary capacitor is electrically connected to the first electrode of the light-emitting element.

18. The display device of claim 14, wherein the driving voltage line comprises the second voltage line and the fifth voltage line.

19. The display device of claim 14, wherein a second electrode of the light-emitting element is electrically connected to a common voltage line, and the common voltage line comprises the third voltage line and the sixth voltage line.

20. The display device of claim 19, wherein each of the plurality of island portions further comprises a first electrode pad electrically connected to the first electrode of the light-emitting element and a second electrode pad electrically connected to the second electrode of the light-emitting element, and
the third voltage line and the sixth voltage line extend to the plurality of island portions and are connect to the second electrode pad.
